(19) Europäisches Patentamt
European Patent Office
Office européen des brevets

(11) **EP 1 743 209 B1**

(12) **EUROPEAN PATENT SPECIFICATION**

(45) Date of publication and mention of the grant of the patent:
**23.11.2016 Bulletin 2016/47**

(51) Int Cl.:
*G02F 1/061* (2006.01)   *G02F 1/1334* (2006.01)
*B23K 26/02* (2006.01)

(21) Application number: **05733435.1**

(22) Date of filing: **15.04.2005**

(86) International application number:
**PCT/AU2005/000537**

(87) International publication number:
**WO 2005/101103 (27.10.2005 Gazette 2005/43)**

(54) **Method of forming an optically active matrix with void structures**

Verfahren zur Herstellung einer optisch aktiven Matrix mit Leerstellenstrukturen

Procédé de fabrication d'une matrice optiquement active présentant des structures vides

(84) Designated Contracting States:
**AT BE BG CH CY CZ DE DK EE ES FI FR GB GR HU IE IS IT LI LT LU MC NL PL PT RO SE SI SK TR**

(30) Priority: **16.04.2004 AU 2004902014**

(43) Date of publication of application:
**17.01.2007 Bulletin 2007/03**

(73) Proprietor: **D.K. AND E.L. MCPHAIL ENTERPRISES PTY LTD**
**Werribee VIC 3030 (AU)**

(72) Inventors:
• **MCPHAIL, Dennis, Kevin**
  **Werribee, Victoria 3030 (AU)**
• **GU, Min**
  **Doncaster, Victoria 3108 (AU)**

(74) Representative: **Gill Jennings & Every LLP**
**The Broadgate Tower**
**20 Primrose Street**
**London EC2A 2ES (GB)**

(56) References cited:
EP-A- 1 549 995       US-A1- 2002 074 537
US-A1- 2003 106 487    US-A1- 2003 214 690

• AN XIANG: "Fabrication of BaTiO3 inverse opal photonic crystal" CHINESE CHEMICAL LETTERS, vol. 15, no. 2, February 2004 (2004-02), pages 228-230, XP002527430
• VENTURA M J ET AL: "Void channel microstructures in resin solids as an efficient way to infrared photonic crystals" APPLIED PHYSICS LETTERS, AIP, AMERICAN INSTITUTE OF PHYSICS, MELVILLE, NY, US, vol. 82, no. 11, 17 March 2003 (2003-03-17), pages 1649-1651, XP012033505 ISSN: 0003-6951
• ESCUTI M J ET AL: "TUNABLE FACE-CENTERED-CUBIC PHOTONIC CRYSTAL FORMED IN HOLOGRAPHIC POLYMER DISPERSED LIQUID CRYSTALS" OPTICS LETTERS, OSA, OPTICAL SOCIETY OF AMERICA, WASHINGTON, DC, US, vol. 28, no. 7, 1 April 2003 (2003-04-01), pages 522-524, XP001160147 ISSN: 0146-9592

EP 1 743 209 B1

## Description

## Background of the Invention

The present invention relates to an optically active element and method of forming an optically active element, and in particular to an optically active element for use as a tunable photonic crystal.

## Description of the Prior Art

The reference to any prior art in this specification is not, and should not be taken as, an acknowledgment or any form of suggestion that the prior art forms part of the common general knowledge.

Optical waveguides (fibres) are used extensively over long haul transmission routes as they enable fast transmission and high bandwidth information delivery. Such waveguides are now used over shorter and shorter distance scales with optical networking becoming the choice for shorter haul networks. In the not too distant future, optical systems will displace conventional electric transmission wires for computer networks, circuit tracks for chip to chip communications and possibly intra-chip transmission and optical processing of data. Such operation requires a level of control over the propagation of light on more intricate level, which can be achieved using periodic dielectric structures which have periodicity of the order of the wavelength of light (known as photonic crystals).

Photonic crystals are structures capable of inhibiting the propagation of light over a spectral region due to a periodic modulation of the dielectric constant. This region of forbidden light propagation is known as the photonic bandgap. Photonic crystals are a phenomenon that has been regularly observed in nature. For example, the colourful iridescence from the wings of a butterfly and the interesting optical effect from the gemstone "opal". Synthetic photonic crystals are those structures generated by humans to manipulate the propagation of light for our purposes. These structures are periodic dielectric arrangements that are precisely engineered for microscopic scattering resonances and Bragg scattering from the dielectric lattice. Featuring sub-micron size structural elements, photonic crystals allow for the manipulation of light on a micrometer scale as is required for electro-optic and all-optical devices, for example by allowing the control of the flow of light into and out of devices in a three dimensional fashion. These structures are capable of use in applications such as sharp angle waveguiding, wavelength division multiplexing, fast optical switching and single mode lasers.

As photonic crystals are the luminary analogues of semiconductors, much research has gone into the development of photonic crystals. One active area is the development of tuneable photonic crystals in which the properties of the bandgap can be altered in some fashion to effect the propagation of light through the structure.

According to Braggs Law, the position of the stopgap is a function of the size of the structural elements (crystal lattice dimensions) and the average refractive index of the material. Therefore, the possibilities for altering the position of the bandgap fall into two categories:

- inducing structural changes via the application of stresses to the crystal structure; and,
- altering the refractive index of the crystal material or filling material.

Applying physical stresses alters the lattice dimensions and hence cause a shift in the bandgap position. These structural changes can give rise to large changes in the position and/or characteristics of the bandgap but are generally not suitable for real-world optical devices as their response time is exceedingly high.

Such charges can be induced by:

1. external compression of the structure and mechochromic effects
2. volume phase transition of hydrogels
3. thermal expansion

Altering the refractive index, car be achieved using:

1. photochemical control
2. non-linear materials
3. thermal phase transition
4. electro/optic/magnetically sensitive materials

The introduction of liquid crystals into the system appears to offer the most promise as they exhibit large variations in refractive index depending upon the alignment state of the director (long molecular axis) of the liquid crystal. Liquid crystals posses an optical anisotropy and the application of an electric field causes a change in the orientation of the liquid crystal directors which inturn causes a variation in the average refractive index.

One method to introduce the liquid crystal into a host polymer is the use of polymer dispersions. In this material, the liquid crystal is dispersed throughout the solid polymer block. The liquid crystal forms into small droplets trapped inside the polymer matrix. Droplet size can be varied in the manufacture process and can be generated from hundreds of microns to a few nanometers. However, materials of this form do not inherently have the necessary refractive index contrast to provide a useable bandgap, and therefore they cannot be used as a photonic crystals.

Most development into tuneable photonic crystals that involves the use of liquid crystals has focussed on infiltration of the liquid crystal into a pre-generated structure such as the inverse opal. This provides the tunability via the application of an external voltage. However, infiltration of liquid crystals into the void regions actually decreases the refractive index contrast and therefore reduces the effectiveness of the system. This in turn makes the use of opal unsuitable for commercial purposes in which tuning of the photonic crystal band gap to a specific frequency range is required.

An Xiang "Fabrication of BaTiO3 Inverse Opal Photonic Crystal" Chinese Chemical Letters Vol. 15, No. 2, pp 228 - 230, 2004 describes a colloidal crystal template or opal with a closed-packed face centered cubic (fcc) lattice, which was prepared from monodisperse polystyrene (PS) spheres by gravity sedimentation. The template was used for the generation of photonic crystal. The template provided void space for infiltration of liquid precursor composed of titanium butyloxide, barium acetate, ethanol, and acetic acid. The opal composite was hydrolyzed, dried, sintered by heating for completely removing PS spheres to form BaTiO3 photonic crystals with inverse opal structure. The PS spheres were replaced by air spheres, which interconnected each other through the windows on the BaTiO3 wall. So both the BaTiO3 wall and air void constitute continuous phases.

WO2004/034134 describes a widely wavelength tunable polychrome colloidal photonic crystal device whose optical Bragg diffraction stop bands and higher energy bands wavelength, width and intensity can be tuned in a continuous and fine, rapid and reversible, reproducible and predictable fashion and over a broad spectral range by a controlled expansion or contraction of the colloidal photonic lattice dimension, effected by a predetermined change in the electronic configuration of the composite material. In its preferred embodiment, the material is a composite in the form of a film or a patterned film or shape of any dimension or array of shapes of any dimension comprised of an organized array of microspheres in a matrix of a cross-linked metallopolymer network with a continuously variable redox state of charge and fluid content. The chemo-mechanical and electromechanical optical response of the colloidal photonic crystal-metallopolymer gel is exceptionally fast and reversible, attaining its fully swollen state from the dry shrunken state and vice versa on a sub-second time-scale. These composite materials can be inverted by removal of the constituent microspheres from the aforementioned colloidal photonic crystal metallopolymer-gel network to create a macroporous metallopolymer-gel network inverse colloidal photonic crystal film or patterned film or shape of any dimension optical Bragg diffraction stop bands and higher energy bands wavelength, width and intensity can be redox tuned in a continuous and fine, rapid and reversible, reproducible and predictable fashion and over a broad spectral range by a controlled expansion or contraction of the colloidal photonic lattice dimensions.

Ventura M. J. et al "Void channel microstructures in resin solids as an efficient way to infrared photonic crystals", Applied Physics Letters, AIP, American Institute Of Physics, Volume 82, Number 11, 17 March 2003 describes microvoid channels generated by local melting in a solidified polymer resin sample moving perpendicular to the focus of a high numerical-aperture objective under visible femtosecond-pulsed illumination. Channel size, surface quality, and high density channel vicinity depended on laser intensity and scanning speed. Electron microscope images revealed elliptical channel cross sections of 0.7-1.3 $\mu$m in lateral diameter and an elongation in the focusing direction of approximately 50%. A 20 layer woodpile-type photonic crystal structure with a 1.7 $\mu$m layer spacing and a 1.8 $\mu$m in-plane channel spacing provided a sharp peak in reflection and a suppression of infrared transmission in the stacking direction by 85% at wavelength 4.8$\mu$m with a gap/midgap ratio of 0.11.

## Summary of the Present Invention

In a first broad form the present invention provides a method of forming an optically active element, the method including:

(a) creating a matrix having an optically active material dispersed therethrough; and,
(b) generating one or more void structures in the matrix.

The method includes forming the void structures using a radiation beam.

Typically the method includes forming the void structures using a laser micro-fabrication process to induce local micro-explosions at a focal spot.

Typically the method includes:

(a) heating a polymer; and,

(b) dispersing liquid crystal throughout the polymer to form the matrix.

Typically the liquid crystals are dispersed so as to form droplets homogenously dispersed throughout the solidified polymeric matrix.

Typically the polymer is a thermoset resin.

Typically the polymer is an unsaturated cross-linked polymer.

Typically the polymer matrix is a polyurethane oligomer with C=C unsaturation and cross-linked by a thiol-ester oligomer

Typically the liquid crystal has an order parameter of between 0.3 and 0.9;

Typically the liquid crystal is a eutectic mixture containing 4-pentyl 4-cyano biphenyl.

Typically the method includes:

(a) heating a polymer material to reduce its viscosity;
(b) adding the liquid crystal to the heated polymer material; and,
(c) agitating the resulting mixture for a predetermined time period to thereby disperse the liquid crystals through the polymer material.

Typically the method further includes curing the resulting mixture in an ultraviolet curing oven to thereby cause the resulting mixture to solidify such that the liquid crystals form droplets homogenously dispersed mixed through the solidified polymer.

Typically the resulting material is cured for at least 30 minutes.

Typically the method further includes adding one or more dopants to the matrix, the dopants being adapted to modify at least one of:

(a) a relaxation rate of the optically active material; and,
(b) optical properties of the matrix.

Typically the dopants include at least one of:

(a) a photo-absorber;
(b) a plasticiser;
(c) inhibitors;
(d) stabilisers;
(e) flame retarders;
(f) hardening agents;
(g) quantum dots;
(h) nano particles;
(i) colouring agents; and,
(j) dyes.

Typically the method includes providing a layer of indium tin oxide on opposing surfaces of the matrix to thereby allow an electrical potential to be applied thereto.

Typically the method includes forming the matrix on a substrate, at least one of the indium tin oxide layers being provided on the substrate using vacuum deposition.

Typically the method includes generating void structures by:

(a) generating a beam of radiation;
(b) modulating the radiation beam; and
(c) focussing the modulated radiation beam onto the polymer matrix to thereby selectively generate void structures.

Typically the method further includes:

(a) filtering the radiation beam; and,
(b) collimating the radiation beam.

Typically the method includes controlling the relative position of the matrix and the radiation beam to thereby generate a predetermined void structure.

Typically the method includes using a radiation beam having at least one of:

(a) a wavelength of between 600 and 800 nm;
(b) a pulse width of between 70 and 90 fs;
(c) a repetition rate in the region of 82 MHz;
(d) a writing speed of between 400 and 600 $\mu$m/s; and,
(e) a power of between 10 and 20 mW at the objective lens.

Typically the optically active element is adapted for use in:

(a) a display;
(b) beam steering;
(c) fluid detection;
(d) tunable lasers;
(e) polarisation multiplexing; and,
(f) optical switching.

Typically the void structure includes at least one of:

(a) one or more void channels;
(b) void dots; and,
(c) one or more layers of void channels.

Typically the void structure includes a plurality of layers of void channels, the void channels in each layer being substantially parallel, and the void channels in adjacent layers being substantially orthogonal.
Typically the structure defines a bandgap, the wavelength of the bandgap being at least partially dependent on a separation of the layers.
In a second broad form the present invention provides apparatus for forming an optically active element, the apparatus including:

(a) a radiation source for generating a beam of radiation;
(b) a shutter, for modulating the radiation beam; and
(c) an objective lens for focussing the modulated radiation beam onto a matrix having an optically active material dispersed therethrough to thereby selectively generate void structures.

Typically the apparatus further includes:

(a) A neutral density filter for filtering the radiation beam; and,
(b) a collimator for collimating the radiation beam.

Typically the collimator is formed from a pinhole and an aperture.
Typically the apparatus further includes a controller coupled to the shutter for controlling modulation of the radiation beam.
Typically the apparatus further includes:

(a) a stand for receiving the matrix; and,
(b) a drive system for controlling the relative position of the stand and the objective lens to thereby control the relative position of the radiation beam and the matrix.

Typically the controller is adapted to control the drive system.
Typically the apparatus further includes

(a) a beamsplitter for reflect radiation, the radiation being at least one of:

(i) radiation reflected from the matrix; and,
(ii) backlight radiation transmitted through the matrix;

(b) a detector for detecting the reflected radiation, the detector being coupled to the controller to thereby perform at least one of:

(i) monitoring of void formation; and,

(ii) controlling at least one of the shutter and the drive system.

Typically the drive system includes:

(a) a first actuator coupled to the lens to control the position of the lens in a first direction;

(b) a second actuator coupled to the stand to control the position of the stand in second and third directions.

Typically the radiation beam has at least one of:

(a) a wavelength of between 600 and 800 nm;

(b) a pulse width of between 70 and 90 fs;

(c) a repetition rate in the region of 82 MHz;

(d) a writing speed of between 400 and 600 $\mu$m/s; and,

(e) a power of between 10 and 20 mW at the objective lens.

In a third broad form the present invention provides an optically active element formed by a method including:

(a) creating a matrix having an optically active material dispersed therethrough; and,

(b) generating one or more void structures in the matrix.

Typically the optically active element is coupled to a tuning mechanism for altering properties of the optically active material by applying at least one of:

(a) an electric field;

(b) a thermal change;

(c) a magnetic field; and,

(d) electromagnetic radiation.

Typically the method including the method of the first broad form of the invention.

In a fourth broad form the present invention provides an optically active element formed from a matrix having an optically active material dispersed therethrough and one or more void structures formed in the matrix using a radiation beam.

Typically the optically active element is coupled to a tuning mechanism for altering properties of the optically active material by applying at least one of:

(a) an electric field;

(b) a thermal change;

(c) a magnetic field; and,

(d) electromagnetic radiation.

Typically the optically active element is formed by a method according to the first broad form of the invention.

In a fifth broad form the present invention provides a product obtainable by the process as defined in the first broad form of the invention.

In a sixth broad form the present invention provides apparatus for beam steering, the apparatus including:

(a) an optically active element formed from a matrix having an optically active material dispersed therethrough and one or more void structures formed therein;

(b) a radiation source for generating a beam of radiation;

(c) a tuning mechanism for altering properties of the optically active material by applying at least one of:

(i) an electric field;

(ii) a thermal change;

(iii) a magnetic field; and,

(iv) electromagnetic radiation.

Typically the optically active element is formed by a method according to the first broad form of the invention.

In a seventh broad form the present invention provides a display including:

(a) a radiation source for generating a beam of radiation;
(b) an optically active element formed from a matrix having an optically active material dispersed therethrough and one or more void structures formed therein; and,
(c) a tuning mechanism for altering properties of the optically active material to thereby direct the radiation beam at a surface by applying at least one of:

(i) an electric field;
(ii) a thermal change;
(iii) a magnetic field; and,
(iv) polarised electromagnetic radiation.

Typically the optically active element is formed by a method according to the first broad form of the invention.

In an eighth broad form the present invention provides apparatus for fluid detection, the apparatus including;

(a) a radiation source;
(b) an optically active element formed from a matrix having an optically active material dispersed therethrough and one or more void structures formed therein, at least one of the void structures being open to an environment to receive fluid therefrom; and,
(c) a detection system for detecting radiation transmitted through the optically active element and determining information relating to fluid in the at least one void structure.

Typically the apparatus includes a tuning mechanism for altering properties of the optically active material to thereby direct the radiation beam at the screen by applying at least one of:

(i) an electric field;
(ii) a thermal change;
(iii) a magnetic field; and,
(iv) polarised electromagnetic radiation.

Typically the optically active element is formed by a method according to the first broad form of the invention.

In a ninth broad form the present invention provides a tunable laser including:

(a) a cavity having two opposing ends;
(b) a radiation source for providing radiation to the cavity;
(c) an optically active element positioned at each end, each optically active element being formed from a matrix having an optically active material dispersed therethrough and one or more void structures formed therein; and,
(d) a tuning mechanism for altering properties of the optically active material of at least one of the optically active elements to thereby control the properties of the resulting laser beam.

Typically the optically active element is formed by a method according to the first broad form of the invention.

In a tenth broad form the present invention provides apparatus for optical switching, the apparatus including:

(a) an optically active element formed from a matrix having an optically active material dispersed therethrough and one or more void structures formed therein, the optically active element being adapted to receive a radiation beam; and,
(b) a tuning mechanism for altering properties of the optically active material to thereby selectively control a direction in which the radiation beam is emitted from the optically active element.

Typically the optically active element is formed by a method according to the first broad form of the invention.

**Brief Description of the Drawings**

An example of the present invention will now be described with reference to the accompanying drawings, in which: -

Figure 1 is a schematic representation of a liquid crystal polymer incorporating a void channel crystal structure;
Figure 2 is a graph showing the differences in bandgap position for different crystals having different structural properties;

Figure 3 is an infrared spectra showing the positions of the fundamental stop gap for a PDLC material with 6% E49 with the layer spacing dz incrementally increasing from 1.1 to 1.5 mm;

Figure 4 is a plot of the predicted position of the bandgap against the actual position of the bandgap for different crystals having different structural properties;

Figure 5 is an example of the chemical structure of a liquid crystal molecule;

Figure 6A and 6B are schematic diagrams of an example of a cell for forming a polymer matrix;

Figure 7A and 7B are schematic diagrams of the alignment of liquid crystal directors within the polymer matrix in the absence and presence of an applied voltage;

Figure 8 is a graph of the optical transmission of the polymer dispersed liquid crystal material with no photonic crystal structure;

Figure 9 is a schematic diagram of an example of apparatus for creating void structures within a polymer matrix;

Figure 10 is an example of the absorption spectrum of NOA63 E49 composite;

Figure 11 is a plot showing the viable condition for generation of void structures in the polymer matrix;

Figure 12A is a microscope image in transmission mode of void rods formed in liquid crystal doped PMMA;

Figure 12B is a reflection confocal image of void rods formed in liquid crystal doped PMMA;

Figures 13A and 13B are electron microscope images of void rods exiting a polymer sample;

Figures 14A to 14C are optical transmission microscope images of examples of photonic crystal structures;

Figure 15 is an example of a raw FTIR spectrum without baseline correction showing band gaps at wavelengths of 2650 cm$^{-1}$ and 5000 cm$^{-1}$;

Figure 16A is a schematic diagram of an example of a void structure used in forming a photonic crystal;

Figure 16B is a raw FTIR spectrum of a photonic crystal incorporating the void structure shown in Figure 16A;

Figure 16C is graph showing the effect of an electric field on the band gap of a photonic crystal incorporating the void structure shown in Figure 16A;

Figure 17 is an example of bandgap suppression as a function of the number of void layers for three liquid crystal concentrations;

Figure 18 is an example of two baseline corrected FTIR spectra showing a shift in the position of the bandgap for an example phonic crystal;

Figure 19 is an example of shifts in the stop gap position with the applied voltage for photonic crystals with 0%, 10%, and 24% liquid crystal;

Figures 20A and 20B are schematic diagrams of the alignment of liquid crystal directors within the polymer matrix in the absence and presence of an applied polarised beam;

Figure 21 is an example of variations in the stopgap position with the period of an applied polarised optical field for 0%, 10% and 24% liquid crystal concentrations;

Figures 22A and 22B are examples of the variations in the bandgap positions with the application of an optical field and an electrical field respectively;

Figures 22C and 22D are examples of the transmission spectra for the application of an optical field and an electrical field respectively;

Figure 23 is a schematic diagram of an example of a fluid detector incorporating photonic crystals;

Figure 24 is an example of the absorption spectrum of $CO_2$;

Figure 25 is a schematic diagram of an example of a photonic crystal used in beam steering; and,

Figure 26 is a schematic diagram of an example of a display incorporating photonic crystals.

## Detailed Description of the Preferred Embodiments

An example of a process for forming tunable photonic crystals will now be described.

The crystals are formed from a matrix incorporating an optically active. In particular, in one example, the crystal is formed from a polymer dispersed liquid crystal (PDLC) or a polymer stabilised liquid crystal (PSLC), which are broad terms to describe dispersions of liquid crystal into a polymer host. The liquid crystals form homogenously into tiny droplets dispersed throughout the solidified polymeric matrix. Droplet size can vary from hundreds of microns to a few nanometres. However, other materials can be used as will be described in more detail below.

The polymer/liquid crystal ratio may be varied, the size of the droplets of liquid crystal may be varied, type of polymer and liquid crystal may be varied, other dopants such as plasticiser or photo absorber may be included, but all fall into the broad category of liquid crystal dispersions in polymers.

The liquid crystal polymer is formed with a homogenous structure and then modified, utilising void channel micro-fabrication, to create arbitrary photonic crystal structures inside a solidified block of liquid crystal polymer.

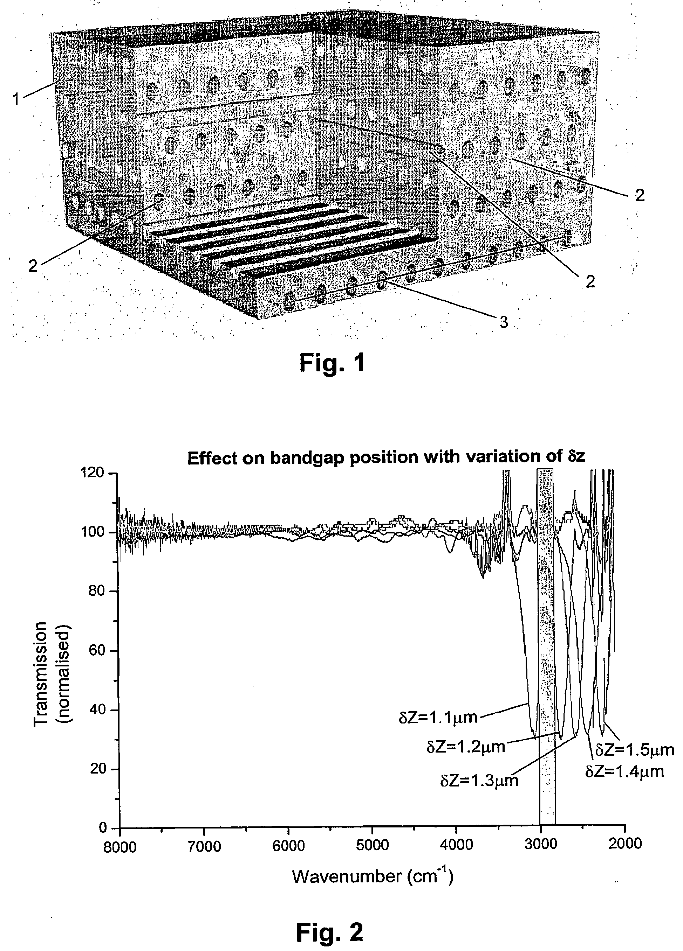

An example of this is shown in Figure 1, which is a graphical representation of a liquid crystal polymer incorporating a void channel crystal structure. In this example, a polymer matrix 1, having liquid crystals dispersed therethrough, includes a number of void channels 2. In this example, the void channels are arranged in layers 3, with each layer being formed from a number of parallel spaced void channels 2, as shown. The void channels 2 in adjacent layers are arranged orthogonally to form a structure referred to as a woodpile structure.

The void channels create a dielectric contrast against the polymer-liquid crystal background, thereby allowing the formation of a bandgap, which can be tuned by altering the optical properties of the liquid crystal. In particular, the application of a voltage across the polymer matrix 1 changes the average alignment of the liquid crystals inside the polymer host, therefore altering the refractive index and hence the position of the photonic bandgap.

The characteristics of the bandgap can best described by "Braggs" equation:

$$m\lambda_{gap} = 2\delta z n_{avg} \qquad\qquad \text{(EQ 1)}$$

Where m is the order of the gap, $\lambda$ is wavelength position of the gap, $\delta$ is the spacing of the structural elements in the z dimension and $n_{avg}$ is the average refractive index of the material.

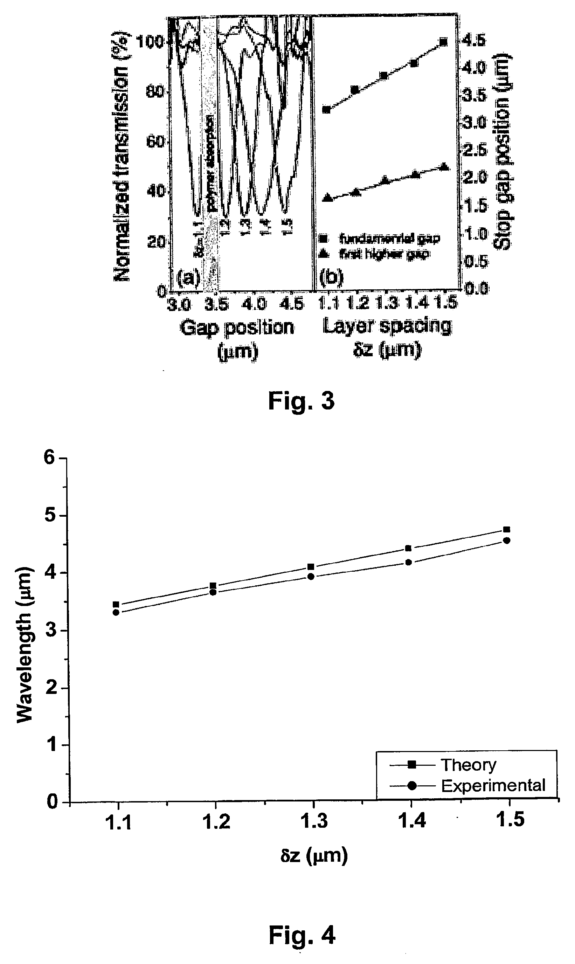

It is possible to alter the structural parameters of the crystal, by adjusting the position of the void channels, to alter the properties of the bandgap. An example of this is shown in Figures 2 and 3, in which five face centred tetrahedral (FCT) woodpile photonic crystals structures were generated with $\delta x$ and $\delta y$ being 1.57 $\mu$m and a variation $\delta z$ increasing in 0.1 $\mu$m steps from 1.1 $\mu$m to 1.5 $\mu$m.

As shown, the position of the bandgap varies for each of the crystal structures, due to the differences in the structural parameters. The shaded region is an area in the spectrum where the polymer has signature absorptions. Thus, in this example, the position of the bandgap moves from approximately 2.3 $\mu$m to 3.1 $\mu$m. Additionally, both fundamental and higher order band gaps are present as shown in Figure 3.

This movement corresponds to that predicted by Braggs equation (Eq 1). This is highlighted by Figure 4, which is a plot of the predicted position of the stopgap against the actual position. This shows a high degree of correlation between the actual position of the gap and the theoretical position, with a small baseline shift from the theoretical position being caused by the average refractive index of the material ($n_{ave}$) being not precisely known.

<u>Matrix</u>

In order to allow a photonic crystal to be produced according to the above described method, the matrix must be capable of hosting homogenously dispersed optically active material, as well as allowing void structures to be formed therein. Thus, it will be appreciated that any suitable material, such as glass, polymers, or the like may be used, depending on the circumstances in which the crystal is to be used and the desired resulting optical properties.

It will therefore be appreciated that the material selected will depend on the required refractive index, which will in turn depend on the desired resulting optical properties.

In the event that a polymer is used, this may be any polymer, but is typically an unsaturated carbon based polymer or oligomer. Examples of suitable polymers include:

- polyurethane;
- polymethylmethacylate;
- polyimide;
- polyamide;
- polyamideimide;
- polyether sulfones;
- polyphenylsulfides;
- poly vinyl alcohol;
- amineformaldehyde;
- thermoset resins;
- any other cross linked polymer.

In one specific example, the polymer used is a polyurethane oligomer having C=C unsaturation and cross-linked by a thiol-ester oligomer (available as part number NOA63 from Norland optical adhesives), which has a refractive index of 1.56.

The matrix material is doped with an optically active material, such as a liquid crystal, or any other optically active material, such as glycerol or the like.

In this regard, suitable materials will include any material having a rod-like molecular structure, or rigidness of the long axis, or strong dipoles and/or other easily polarisable substituents. In particular, these features allow the optical properties of the material to be easily manipulated, for example through the use of suitable external electric, magnetic or optical fields.

The tendency of molecules to align along a common axis, or director, can be used as a measure of order within the liquid crystal, which in turn is represented by an order parameter. For a perfect crystal, in which all the molecules are aligned, the order parameter evaluates to one. Typical values for the order parameter of a liquid crystal suitable for use in the current techniques range between 0.3 and 0.9.

A further point of note is that the order is typically a function of temperature of the liquid crystal, and this can therefore be used in temperature based tuning systems.

In any event, the properties of liquid crystals are generally further characterised by positional order, orientational order, and bond orientational order and these would also be selected based on the particular application.

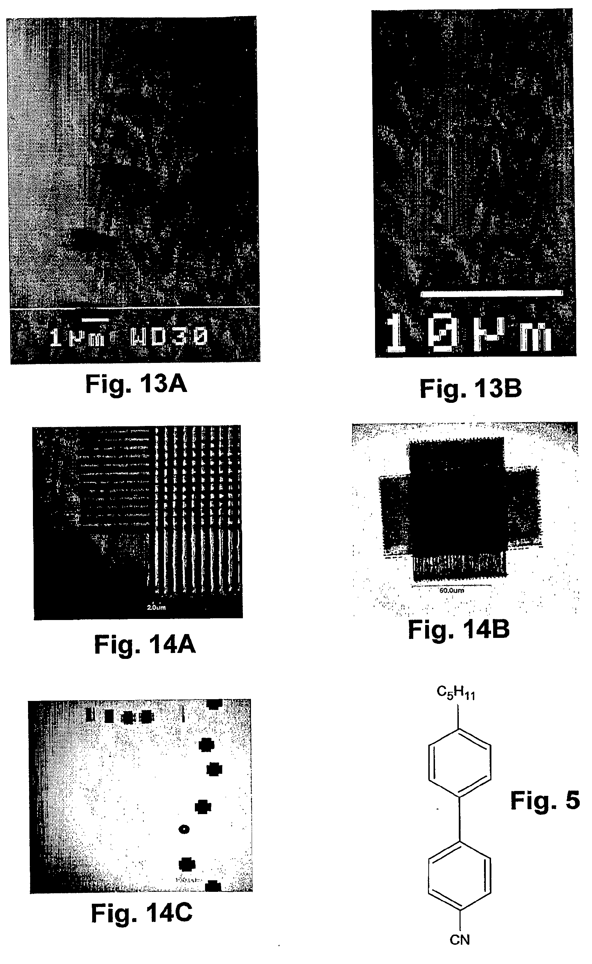

In one specific example, the liquid crystal used is a eutectic mixture containing 4-pentyl 4-cyano biphenyl (available as E49 from Merck) having an extraordinary refractive index of 1.74 and an ordinary refractive index of 1.53. An example of the structure of the liquid crystal molecule is shown in Figure 5.

In this specific example, to create the polymer matrix 1, the NOA63 resin is heated to reduce its viscosity and the liquid crystal added. The mixing ratio was 20% liquid crystal and 80% polymer by weight. The mixture is stirred, typically for 10 minutes, and then cast into a pretreated structure.

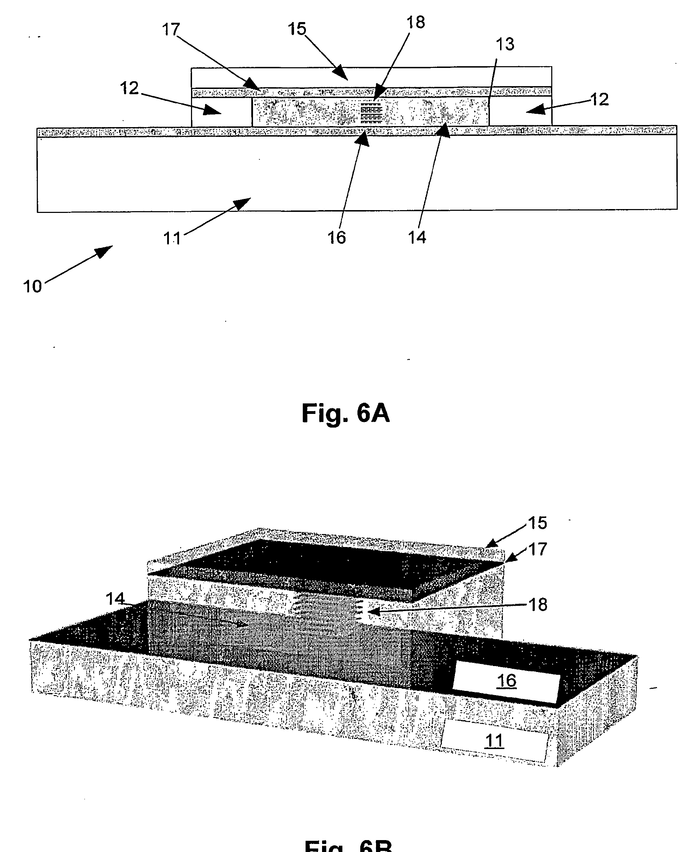

An example of a suitable structure for experimental purposes is shown in Figures 6A and 6B. In this example, the structure is a cell 10 formed from a glass microscope slide 11, and spacers 12, which act to form a well like structure 13, for receiving the polymer 14. A pretreated glass cover slip 15 is placed on top of the cell 10, with the polymer/liquid crystal mixture completely covered by the cover slip 15. In one example, the spacers 12 are formed from acrylic tape with a thickness in the region of 120-140 $\mu$m.

The cell 10 is placed in an ultraviolet curing oven for 40 minutes, thereby causing the resin to quickly solidify, which in turn causes the liquid crystals to form into tiny droplets homogenously mixed through the solidified polymer. One method to decrease the curing time is to raise the temperature of the sample as it is cured by the UV radiation. This has the effect of minimising the liquid crystal droplet size. Another method to ensure small droplets is to irradiate the sample with an ultrasonic source as it is cured by the UV oven.

Once the material has been cured, structure can be written into the polymer matrix, such as a woodpile structure shown at 18, as will be described in more detail below.

To allow the properties of the polymer matrix to be altered, an electrical signal can be applied to the polymer matrix to thereby causing liquid crystal director alignment. In the arrangement of Figure 6, the cell can include transparent electrodes 16, 17 mounted on the glass slide and the cover slip 15 respectively.

This can be achieved using a thin film (approx. 35 nm) of indium tin oxide (ITO) laid down using vacuum deposition. This electrically conductive thin film is effectively transparent to infrared and visible light but allows an electric potential to be applied to either side of the cell 10. No other insulating film was placed over the ITO coating. Wires can be connected to the electrodes 16, 17 to allow a voltage to be applied.

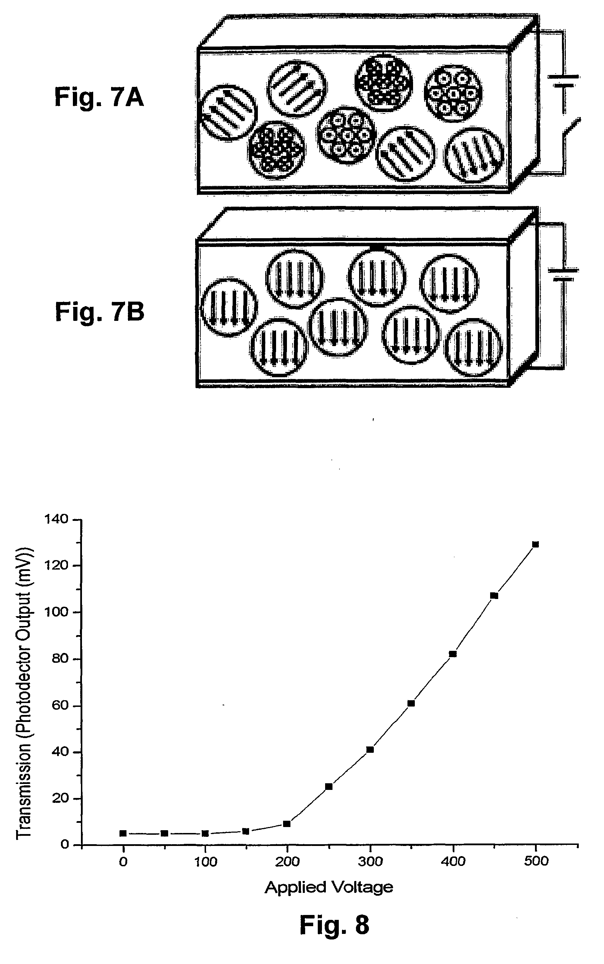

Voltage applied to the transparent electrodes (ITO) has the effect of changing the alignment of the liquid crystal directors. The response of these liquid crystals to an applied field depends upon the sign of the dielectric anisotropy. In this case, the dielectric anisotropy is positive, therefore the directors align parallel to the applied electric field. An example of this is shown in Figures 7A and 7B, which show the alignment of the liquid crystal directors with no field applied and with a field applied respectively.

The prepolled state (no voltage applied) is approximated as a random liquid crystal director alignment with its long molecular axis freely positioned at any angle $\theta$ relative to the electric field. Using an ellipsoidal relation results in an average refractive index of $n_{LC}^{prepolled}=1.60$. As E49 has a positive dielectric anisotropy, the directors align parallel to the applied electric field reducing the refractive index of the liquid crystals to $n_{LC}^{polled} =n_{LC}^{o}$ (which is the ordinary refractive index of the liquid crystals). This controlled refractive index variation tunes the position of the band gap to shorter wavelengths by operating on the average refractive index $n$avg of the composite material.

To characterise the cell with no structure inside, an increasing potential up to 500 volts DC was applied and the transmission of the cell was recorded. The transmission remains low until a threshold voltage is reached and then there is a distinct increase in transmission as more liquid crystals align with the applied voltage. This is attributed to the Freedericksz transition, where the torque from the applied electric field deforms the current director configuration and commences an abrupt orientational onset. As shown in Figure 8, this abrupt onset occurs at approximately 150 volts DC.

*Dopants*

The matrix can include additional dopants such as photo-absorber, plasticiser, inhibitors, stabilisers, flame retarders, hardening agents, colouring agents, dyes, impact modifiers etc. Dopants can be provided for a number of reasons.

For example, the presence of dopants can be used to alter the optical properties of the polymer matrix, thereby changing the optical properties of the resulting photonic crystal. This can include for example, altering the refractive index, the transmissive properties, or the like.

This in turn may also have an impact on void structure formation. Thus, in the above example, the NOA63 resin includes photo absorbers, which assist in the void structure formation process.

Additionally, the dopants may influence other factors, such as the curing process.

Additionally, the dopants may have an impact on the interaction of the liquid crystal, or other optically active material, with the resin. For example, the dopants can influence mechanical coupling between the optically active material and the resin, which thereby alters the ability of the liquid crystal molecules to move between the random and aligned states. Thus in turn can influence the tuning properties of the resulting photonic crystal, as will be described in more detail below.

Structure Formation

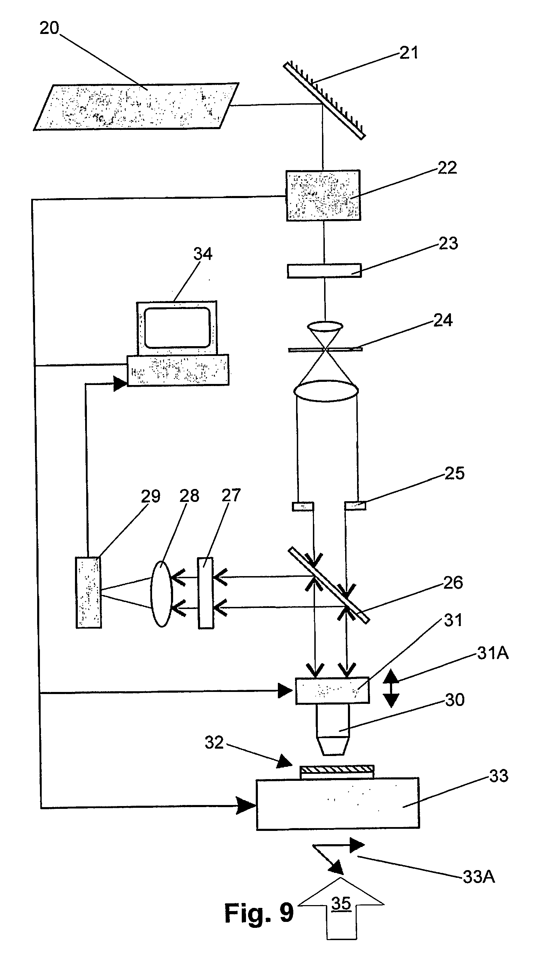

An example of a system for generating arbitrary structures within the polymer matrix will now be described with respect to Figure 9. In particular, the apparatus includes a laser 20 for generating a beam of radiation, which is reflected from a mirror 21 and passes through a shutter 22, a neutral density filter 23, a pinhole 24 and an aperture 25, to a dichroic beamsplitter 26.

The laser light passes through the beamsplitter 26, and then through an objective lens 30, whose position is controlled via an actuator 31, and is focused on to a sample 32 provided on a stand 33. The actuator allows the objective lens 30 to be moved in a z-direction (as shown by the arrows 31 A), whilst the stand is moveable in the x- and y-directions (as shown by the arrows 33A). This allows for relative positional control between the focal point of the laser beam and the sample 32.

A white light source is also typically provided for back lighting the sample, as shown by the arrow 35. In use, the beamsplitter 26 directs backscattered illumination, as well as light from the white light source through the sample to allow monitoring of the fabrication process in real time. The short pass filter 27 ensures that minimal laser light makes its way through a lens 28 to the CCD camera 29. A computer system 34 is also provided, coupled to the CCD array 29, the shutter 22, as well as the actuator 31 and the stand 33.

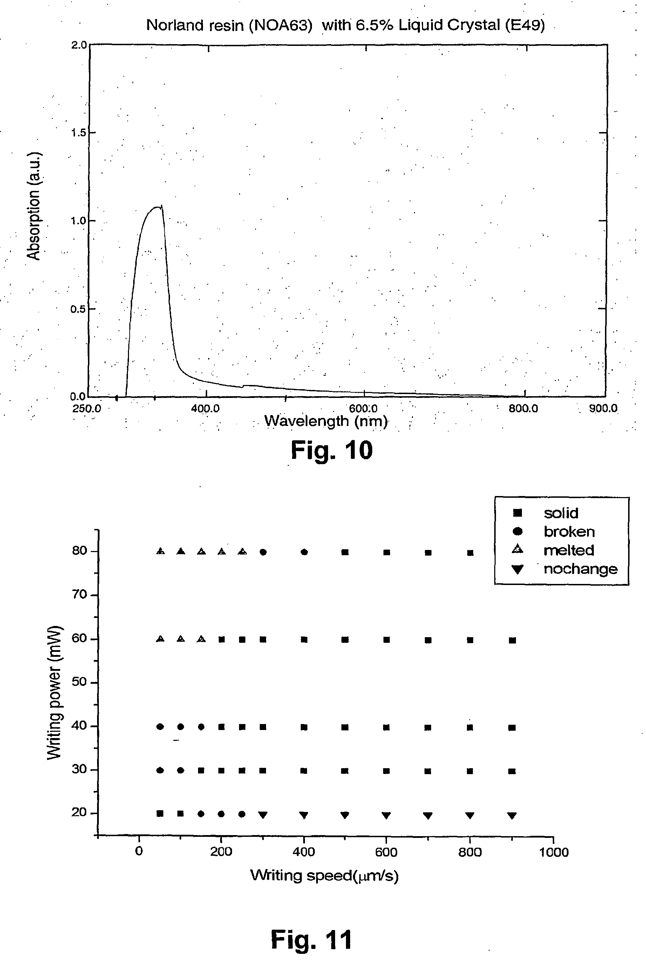

In use, the apparatus uses a femtosecond laser micro-fabrication process to generate any arbitrary structure. As can be seen from the absorption spectrum shown in Figure 10, the absorption of the polymer matrix is negligible at a wavelength of 700 nm, thereby allowing a laser with a wavelength of 700 nm can be used in the writing process.

However, it will be appreciated that this value depends on the optical properties of the matrix and will therefore be influenced by factors such as the polymer selected, and the presence or absence of additional dopants.

In any event, in this example, the laser 20 is a Spectra-Physics Tsunami (Ti-Sapphire) ultrashort-pulsed laser operating at 700 nm, which produces an ultrashort-pulsed beam that has a pulse width of 80 fs and a repetition rate of 82 MHz. The laser beam is focused onto the sample 32 by the objective lens, which in this example is an Olympus 60x 1.45 oil *immersion* objective. A writing speed of 500 $\mu$m/s can be used with a writing power of 14 mW at the back aperture of the objective.

The inherent sectioning properties of the multi-photon process enables depth discrimination, therefore allowing the structures to be written inside the polymer without affecting the remaining material.

To achieve this, the computer system 34 activates the shutter 22 to control the speed and exposure time of the laser, with the relative position of the sample 32 and objective lens 30 being controlled by the computer system 34. In one example this is achieved using a Physik Instrumente (PI) micro-positioning system that translates 200 by 200 $\mu$m in the x-y and 350 $\mu$m in the z axis (depth). This provides 10 nm resolution and 100 nm repeatability.

The structures are formed when the ultrashort-pulsed laser light is focused tightly into the material inducing local micro-explosions at the focal spot, which generates voids in the solid liquid crystal doped polymer. Translation of the polymer block allows the formation of continuous void channels, which were stacked to create an inverse woodpile structure. The void channel dimensions are determined by the material used, the laser wavelength, the numerical aperture, the translation speed, the pulse repetition rate of the laser and the pulse width of the pulses used

To choose the correct writing power and speed, the material can be characterised to identify the correct parameters for efficient generation of the void structures. An example of this shown in Figure 11, which is a plot showing in black squares, the parameters which allow for optimal void structure generation. When the translation is too fast or the writing power is too low; consistent void formation does not occur. Thus in the case of forming void rods or channels, the result is broken lines or no void formation at all. If the power is too high or the speed is too slow, the uncontrolled explosions and damage to the material occurs. Previously formed voids may collapse if the writing power used for forming later voids is too high.

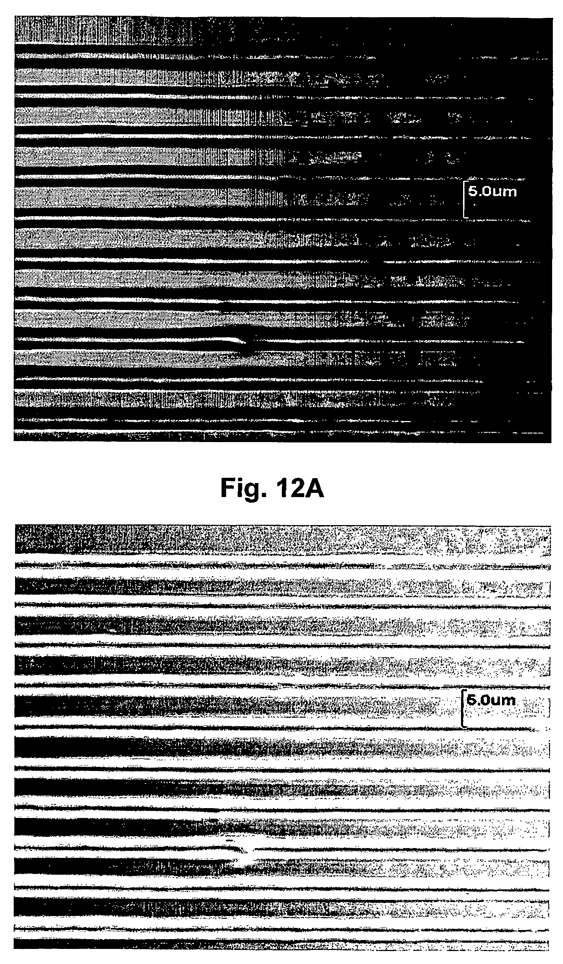

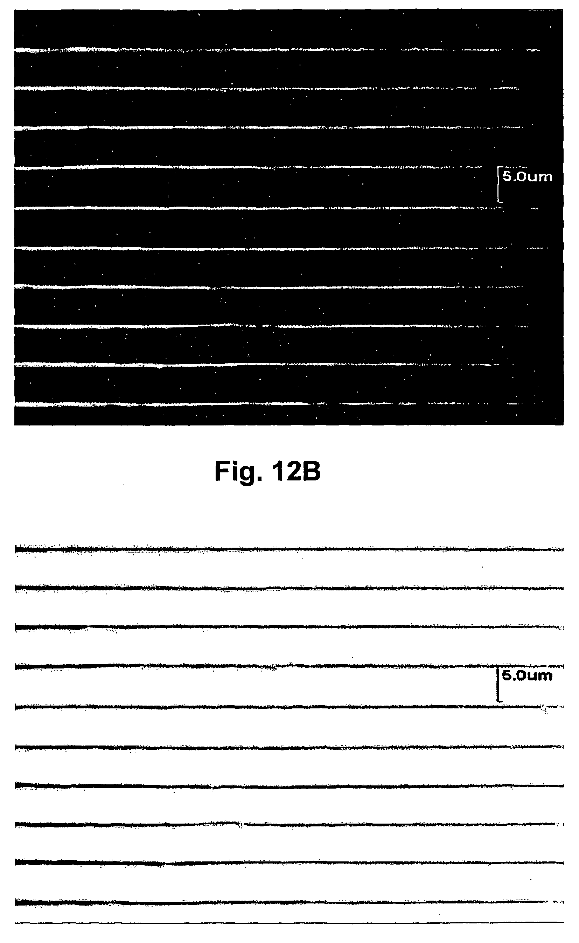

Figures 12A and 12B are images of void rods formed in liquid crystal doped PMMA. The rods were written with 810 nm femtosecond pulsed laser light with 200 $\mu$m/s, with a 100x 1.4 NA objective. The images were obtained using an Olympus BX microscope using continuous wave 632.8 nm laser light illumination, with Figure 12A being a transmission image from an optical microscope illuminated with 632.6 nm, whilst Figure 12B is a reflection confocal image. Both of these Figures include negative and positive images for reproduction clarity.

In any event, these Figures show a high degree of correlation of the rod structures generated in the liquid crystal doped polymer. In this example the material used was polymethylmethacrylate (PMMA) and E49 liquid crystal (5:95 %wt - E49:PMMA).

As evidence that the structures are hollow channels (which may contain vapours) - the reflection confocal image shows a very large change in refractive index, which is caused by the sharp mismatch in refractive index between the polymer blend and the hollow void.

Figures 13A and 13B show electron microscope images of a void rod structures written through a liquid crystal polymer sample (6.5:93.5%wt E49:NOA63) and out of one side of the material. The sample contained 6.5% E49 and 93.5% NOA63. The structures were written with a wavelength of 700 nm and a 60x NA 1.45 Olympus objective. The writing speed was 500 $\mu$m/s and writing power was 60 mW.

The samples imaged above were cleaned with alcohol and imaged with an electron microscope after they were coated in gold.

The image shown in Figure 13A shows the rods exiting the liquid crystal polymer block. These images were taken from an angle to show the hole structure, which in this case was approximately 1.2 $\mu$m in size. Figure 13B shows four rods exiting at one depth and another four rods exiting at a level 2 $\mu$m deeper into the sample.

The multi-photon micro-fabrication process allows the easy generation of arbitrary structures. Figures 14A to 14C show an example of a woodpile structure created with alternating dielectric layers. To generate this photonic crystal, the rods are stacked into an inverse woodpile structure with alternating layers of crisscrossed rods with each other layer being offset by half of the in-plane spacing. This shape creates a unit cell of a face centred tetrahedral.

Figure 14A shows layered rods extending in orthogonal directions at different levels of depth, whilst Figure 14B shows a complete crystal structure. It should be noted that the rods extend out of the structure in orthogonal. This keeps high correlation and low distortion of the rods that participate in the actual crystal structure. Usually, any distortions in the rod shape and size occurs at the beginning of the rod. Therefore, generation of the photonic crystal in this way keeps these unwanted artefacts out of the crystal structure. Figure 14C is an image zoomed further out to show a number of photonic crystals built in a single sample.

It will be appreciated that this allows a variety of different structures to be created within the polymer matrix, thereby allowing a range of different optical properties to be obtained for the resulting photonic crystals.

Utilising these techniques it is possible to generate band gaps that provide suppression of the transmission observed near a wavelength of 4.5 $\mu$m with an extinction of greater than 75% in a 20 layer structure.

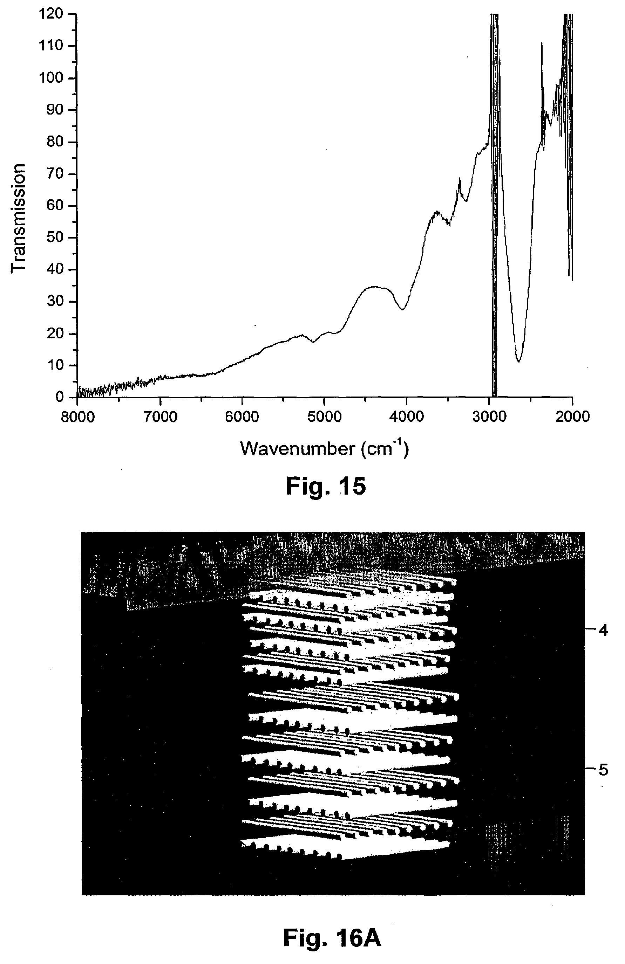

Figure 15 shows a bandgap at 2650cm$^{-1}$ with structural parameters $\delta z = 1.3$ $\mu$m and $\delta x$ and $\delta y = 1.57$ $\mu$m. It should be noted that at around 5000 cm$^{-1}$ a higher order bandgap is present. This (partial) bandgap is created in the shorter wavelength regime - towards the communications wavelengths so may provide an avenue to operate these devices at more useful wavelengths. This graph shows raw data without the background spectrum removed.

An underlying feature of the above described method of manufacture is the ability to create any arbitrary configuration, which in turn influences the properties of the resulting photonic crystal.

An example of this will now be described with respect to Figure 16A, in which a dual crystal structure is formed by creating two woodpile structures 4, 5, each of which has different relative spacing between the layers 3 to provide different bandgap properties.

To test the relative properties of the structures, three crystals were made. Two of these include a single woodpile structure, one having a layer separation $\delta z=1.15\mu$m (similar to the woodpile structure 4) and the other having a layer separation $\delta z=1.30\mu$m (similar to the woodpile structure 5). The third crystal is the composite structure shown in Figure 16A, in which two woodpile structures are stacked on top of each other as shown.

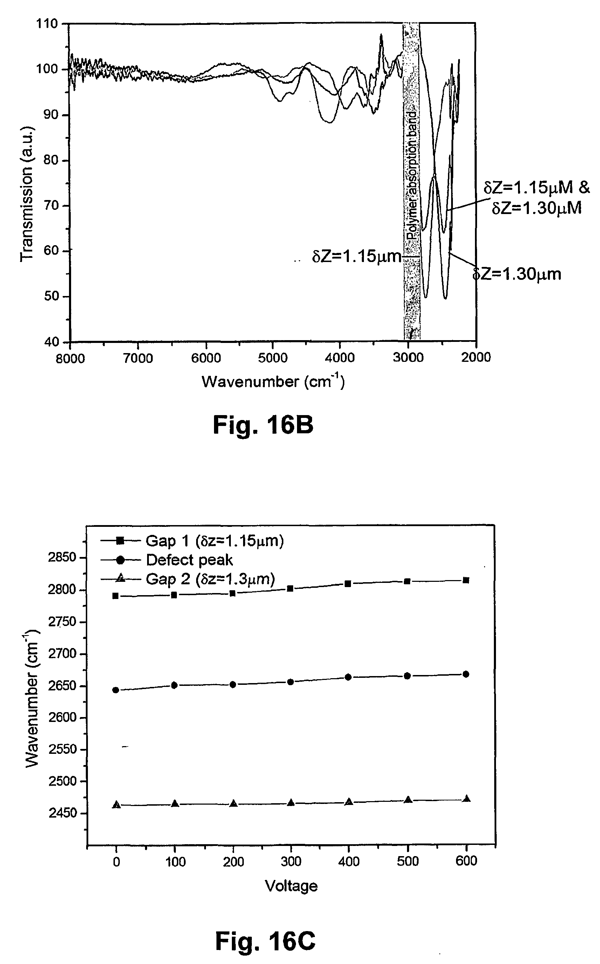

Figure 16B shows the configuration of the bandgap for each of the three crystal structures. In particular, for the structure having a layer separation $\delta z=1.15\mu$m the bandgap is centred at 2734 cm$^{-1}$, whilst for the structure having a layer separation $\delta z=1.30\mu$m the bandgap is centred at 2329 cm$^{-1}$. In the case of the structure shown in Figure 16A, the photonic crystal demonstrates a bandgap at each of the above mentioned wavelengths, as well as a narrow peak that is situated between the two bandgaps, as shown.

This technique therefore allows defects to be easily engineered to allow custom bandgaps to be defined. An important quantum optical consequence of a photonic bandgap is that spontaneous emission of excited atoms or molecules inside the crystal can be completely inhibited. Controlled defects in the photonic crystal can result in localised states in the bandgap, as light is trapped inside the crystal and propagation is prevented. Tuning the properties of these crystals and defects allows engineers free reign to design novel photonic devices based on this invention. By generating structures with missing void rods in particular predefined positions - optical waveguiding capabilities can occur.

To assess the maximum quantity of liquid crystal allowable for efficient void channel generation, four cells were manufactured with concentrations of liquid crystal of 0%, 10%, 24%, and 30%. Cells with higher concentrations were increasingly unstable with consistent void channel formation impossible at 30% and higher for the polymer/liquid crystal combination described in the above example.

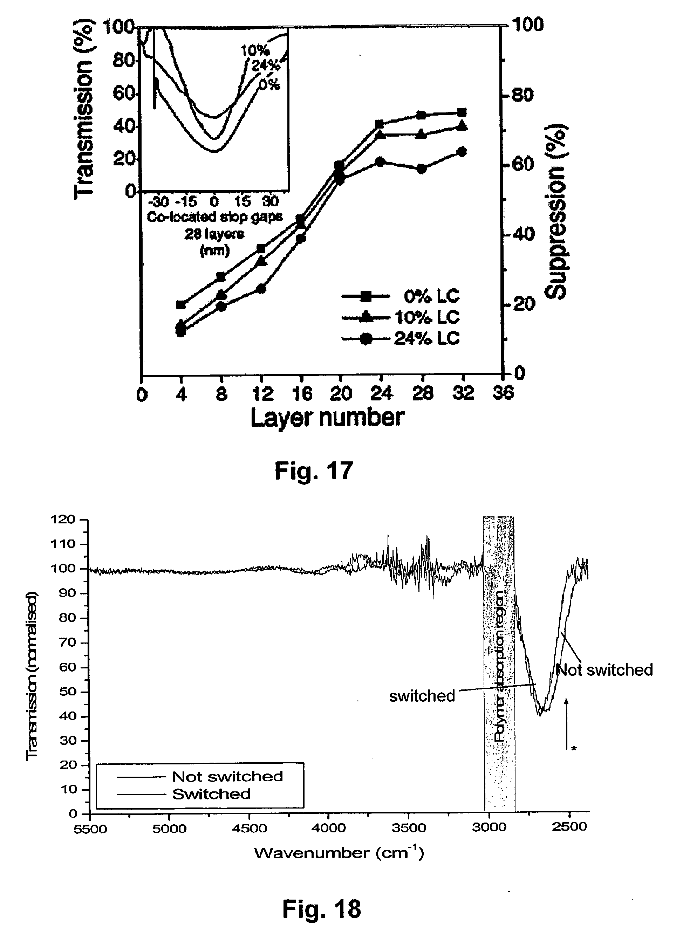

The degree of gap suppression as a function of number of layers and liquid crystal concentrations is shown in Figure 17. As the amount of liquid crystal increases, the effects of scattering of the writing beam (inhibits delivery of writing power) and inhomogeneities of the material (microchannels start to fill with liquid crystal) result in a plateauing of the suppression values.

Thus, an increased concentration of liquid crystal, leads to poorer void formation, which in turn leads to a reduction in transmission suppression of the resulting photonic crystal. This is shown in Figure 17, in which the suppression is greater for crystal having 0% liquid crystal doping. However, it will be appreciated that the lower the concentration of liquid crystal, then the less optically active material there is present in the photonic crystal. As a result the overall change in refractive index of the matrix which can be achieved is reduced, and hence the ability to tune the bandgap is reduced. Accordingly, whilst a lower concentration of liquid crystal allows for improved suppression, it leads to a corresponding decrease in tuning ability.

It will be appreciated that it is not necessary to have complete band gap for all applications. In other words, complete suppression of transmission is not always required, and hence the concentration of liquid crystal used will depend on the circumstances in which the resulting photonic crystal is used, and hence the desired properties.

*Post Processing*

In general the void structures formed by the process outlined above can have a limited range of dimensions, due to the inherent nature of the formation process. Accordingly, in some circumstances it is desirable to perform post-processing on the generated structures to thereby manipulate the dimensions of the void structures, and thereby alter their optical properties.

For example, the resulting photonic crystal can be heated and stretched to thereby reduce the dimensions of the void structures. This in turn alters the wavelength response of the void structure, and in particular reduces the wavelength of the bandgap.

This can be used to allow the void structures to be further manipulated for specific uses, such as use in telecommunications or the like.

Bandgap Tuning

As described above, band gap tuning is achieved by altering the refractive index of the optically active material. The manner in which this is achieved will depend on the nature of the optically active material, and can be achieved for example by the application of magnetic, electrical or polarised electromagnetic fields. In addition to this however, other changes, such as thermal or mechanical changes in the photonic crystal can also alter the refractive index and allow bandgap tuning to be achieved.

A further factor which influences the nature of the tuning is the interaction between the optically active material and either the matrix material or any dopants therein. For example, the presence of dopants can alter the degree of coupling between the molecules and the matrix, and therefore influence the ease with which the liquid crystal directors can be aligned. This in turn alters the ability of the liquid crystal to switch between alignment states.

For example, when the optically active material is moved from an original to a modified refractive index state, by the application of an external control such as an electric field, this will cause corresponding movement of the bandgap. When the field is removed, the time taken for the optically active material to revert to the original refractive index, and hence for the bandgap to return to its original value, is characterised by a relaxation rate.

Selection of an appropriate combination of matrix and dopants can provide an arrangement in which the optically active material has a high relaxation rate. As a result, as soon as the external control, such as the electric field is removed, the optically active material returns to its original refractive index state, and the bandgap therefore reverts to its original position. This therefore provides a self-erasing arrangement in which the photonic crystal reverts to its original state when an external control is removed.

As an alternative, a low relaxation rate can be provided, so that the bandgap remains at the modified refractive index for a time period after the external control is removed. In extreme circumstances, the relaxation rate can be reduced to such a degree that the optically active material effectively remains at the modified refractive index permanently until additional external control is applied. This therefore provides an arrangement in which a change in bandgap is effectively permanent unless altered by the application of additional external control.

It will be appreciated from this that the arrangement, and in particular, the dopant, matrix, active material combination will be set based on the intended usage of the photonic crystal.

Thus, for example, permanent arrangements, can be used in data storage applications. One example of such a permanent arrangement is formed from a E49:PMMA matrix doped with TNF (2,4,7 Trinitro 9 fluorenone), and a plasticiser ECZ. In this case, the dopants interact with the E49 liquid crystal to thereby minimise the relaxation rate, and hence maximise the relaxation time, thereby making this combination suitable for data storage.

*Electrical Bandgap Tuning*

As discussed above, when an electric field greater than the Freedericksz transition voltage is applied, the liquid crystals begin to rotate along the lines of applied electric field. This has the effect of varying the refractive index and according to Bragg's law also varies the bandgap position.

The position of the bandgap can be measured with a Nicolet Nexus Fourier Transform Infrared spectrometer with a Continuum infrared microscope to analyse the spectral throughput of the crystal structure. The objective and condenser can use a 32x NA0.65 (infrared) corrected for glass slide and coverslip. Each spectrum consisted of 200 scans with a resolution of 4 cm$^{-1}$.

Figure 18 shows one such scan of an example crystal where the initial bandgap was measured. Immediately after the scan, voltage was applied to the cell and another FT-IR spectrum was taken. In this example, there was movement in the bandgap of approximately 40.4 nm ie. shifting from 3765.823 nm to 3725.402 nm. This shift occurs with the application of 550 volts DC to the ITO electrodes at each surface of the cell.

An example of the impact of an electric field on the photonic crystals discussed above with respect to Figures 16A and 16B is shown in Figure 16C. Again, this demonstrates an increasing bandgap wavelength as the applied electric field is increased.

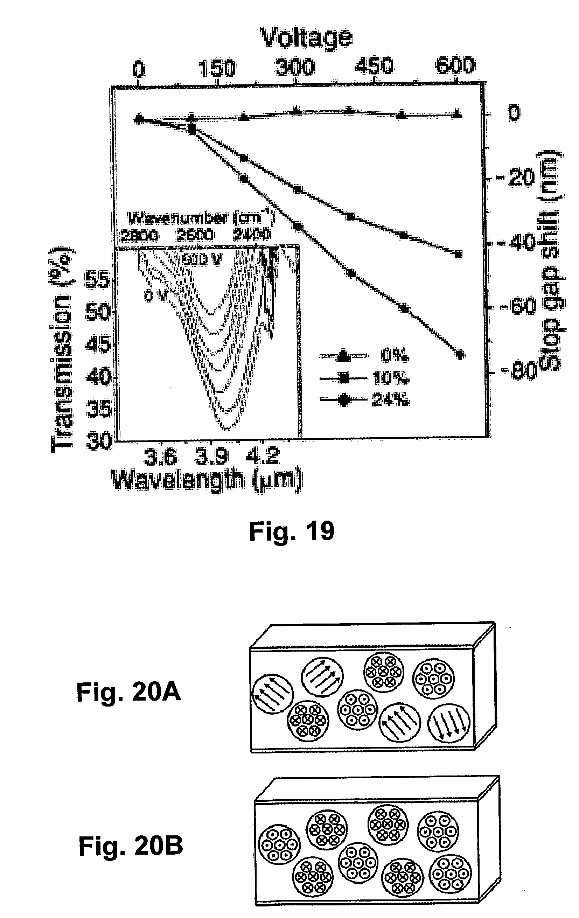

A further example is shown in Figure 19 in which the cells discussed with respect to Figure 17 are characterized by applying an increasing potential up to 600 V to each cell and the infrared transmission spectrum of the crystal was recorded. Again there is little change in the spectral position of the band gap until a threshold voltage of approximately 100 V is reached where there is a distinct variation at the Freedericksz transition. After the onset, a roughly linear increase in the band gap position is observed with the increasing electrical potential. This increase plateaus as the maximum number of liquid crystal molecules participate in the alignment process.

At a potential of 600 V, a maximum deflection of the band gap of 74 nm is observed for the 24% sample. The 74 nm spectral shift is larger than that one may expect from an initial randomly oriented liquid crystal state. However, this result may be expected when initial partial in-plane alignment of the liquid crystals by the E-field of the writing laser beam may occur during the manufacture process. The first higher-order stop gaps also exhibits a controlled variation with the applied potential.

This translation can have a significant impact on the optical properties of the crystal. For example, illumination of this photonic crystal at the band edge by a laser source sees a significant change in transmission as the bandgap is tuned. The steep slope on the sides of the gap allows small movements in gap position to be of great consequence for manufacture and use of photonic devices.

*Optical Bandgap Tuning*

In addition to tuning the bandgap using an electrical field, the re-alignment of liquid crystal directors in PDLCs can also be achieved by illumination of the sample with an external polarised optical field. This provides a mechanism for optical tuning of photonic crystals.

This can be achieved using the crystal structures described above with respect to electrical tuning, and these will not therefore be described in further detail.

As in the case of electrical bandgap tuning, the physical reason for fluorescence of the PDLC under two-photon 4 excitation is the re-alignment of liquid crystal directors along the polarisation direction of the illumination laser beam. Thus, when no optical field is applied, the liquid crystal director alignment is random, as shown in Figure 20A, with its long molecular axis freely positioned at any angle resulting in a refractive index of 1.60. As E49 has a positive dielectric anisotropy, the directors align parallel to an applied electric field vector so that if a linearly-polarised optical beam is incident along the stacking direction, the directors rotate to align perpendicular to the stacking direction of the photonic crystal, as shown in Figure 20B. Accordingly, if the laser beam is scanned along its polarisation direction, this aligning process is enhanced, producing a refractive index of 1.74.

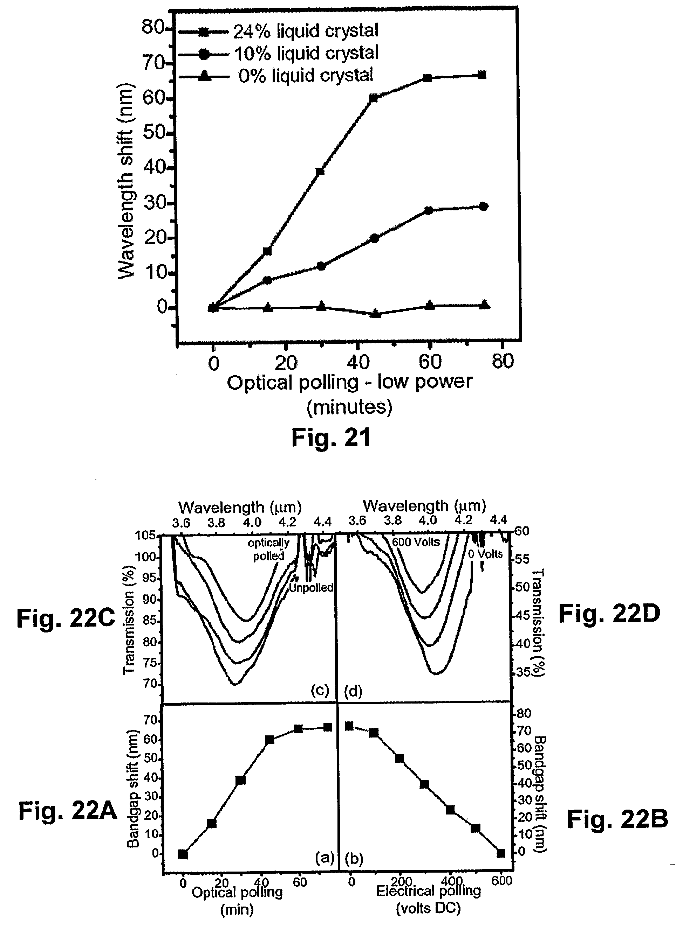

This optical polling/tuning process leads to a shift of the stop gap to a longer wavelength direction. An example of this is shown in Figure 21, which shows variations in the stopgap position for an applied polarised optical field for cells having 0%, 10% and 24% liquid crystal concentrations, as discussed above with respect to Figure 17.

Optical tuning can be achieved using a HeNe laser (632.8 nm) of power 30 mW which is scanned across the structure in a two-dimensional raster fashion. The infrared spectrum of optically-polled structures, measured with a Nicolet Nexus Fourier transform infrared spectrometer with a continuum infrared microscope to analyse the spectral throughput of the crystal in the stacking direction. The unpolarised infrared light from the spectrometer has no effect on the alignment of the liquid crystals.

As shown, the sample with 0 % liquid crystal doping demonstrates no variation in position of the bandgap after the structure was illuminated with the HeNe laser. However, a roughly linear shift in bandgap position can be seen in both the 10% and 24% samples until a maximum number of liquid crystals participate in the alignment process. The 10% sample sees a maximum wavelength shift of approximately 30 nm and the 24% sample providing a 65 nm wavelength shift. Consistent with Bragg's equation, the bandgap shifts to the longer wavelengths as the average refractive index increases.

*Combined Tuning*

The optical and electrical tuning methods described above can be combined, to allow the position of the bandgap to be shifted optically to a longer wavelength, as shown in Figure 22A. The wavelength of the bandgap can then be then shifted back to a shorter wavelength with the application of a voltage to the cell as shown in Figure 22B.

This method of combined optical and electrical tuning allows the bandgap to be swept back and forth over a 65 nm region with optical polling seeing the bandgap shift to the longer wavelengths and electrical tuning shifting it back to the shorter wavelengths. Figures 22C and 22D show the FTIR spectra of this tuning process.

The directors can also be returned to their unaligned state by the application of high intensity UV illumination. This has the effect of redistributing the liquid crystal directors back to their random state.

Variations

It will be appreciated that the above described techniques are examples only and a number of variations may be implemented.

For example, the above examples utilise the active properties of liquid crystals when they are doped into a host material. In the above examples, the host material is a polymer (PMMA, NOA63 etc) but other host materials may be used such as glass or crystals providing void structures can be generated in it. Similarly, other liquid crystals may also be used.

The void channels may be elongated rods, holes, layers or other shapes.

The fabrication process described utilises a pulsed laser is one method for generation of the void structures in the liquid crystal polymer but other methods may be used such as lithography techniques, etching or layer by layer deposition etc.

The interior of the "void channel" structures may be empty space or may be a combination of gaseous residues of the ablation process. Additionally, where the channels exit the liquid crystal polymer block, the channels may be infiltrated with another material of high refractive index to tailor the properties of the photonic bandgap.

If the channels are open to the environment, environmental gasses or liquids may fill the voids, allowing these materials to affect the optical properties of the structure. The results of which allow the structure to be used to detect specific gasses (when signature wavelengths are propagated through the structure).

The void structure may be a one, two or three dimensional structure such as a one dimensional Bragg reflector or a channel to funnel light in a two dimensional photonic crystal waveguide.

Other harmonics of the bandgap may be targeted for use such as the second or third harmonic, which brings the spectral position of the bandgap more towards the "communications" wavelengths.

The liquid crystal polymer may be formed into simple block or it may be stretched into an optical fibre. The void channel structure can be written into the optical fibre and the properties of the liquid crystal could be used to tune the characteristics of the optical fibre.

The device may form part of a display system where light throughput is controlled by the void channel liquid crystal structures.

As liquid crystals are sensitive to different effects, this invention may be tuned with the application of an AC or DC electrical potential or may be tuned via temperature, magnetic or optical fields.

Other materials may be included in the liquid crystal polymer such as photo-absorber, plasticiser, inhibitors, stabilisers, flame retarders, quantum dots, nano-particles, hardening agents, colouring agents, dyes, impact modifiers etc.

The void structures in the liquid crystal doped polymers may be used for optical data storage or for tracking mechanism for optical disks.

The photonic crystals may be used for waveguides, splitters, junctions and couplers, for applications in optical circuitry, integrated optics, and active waveguide devices.

Applications

Some specific applications of the above described photonic crystals will now be described.

*Fluid and Gas Detection*

By implementing a photonic crystal having void structures open to the environment, this enables fluids from the environment to infiltrate the void structures, which in turn alters the optical properties of the photonic crystal.

In particular, if a gas infiltrates the void structures which has a different refractive index to air, this will alter the position of the band gap, thereby allowing the presence of the gas to be detected. Furthermore, by analysing changes in the band gap this allows the nature and concentration of the gas to be determined.

Thus, the liquid crystal alignment and illumination source can be modified allowing the detector to be fine tuned for specific types of gas or agent, such as $CO_2$, CO, cs, sarin, or rycin etc. Certain signature peaks can be searched for therefore allowing the identification of target chemicals.

In order to implement a detector it is typically to provide a number of photonic crystals 40 (six shown for the purpose of example only) coupled to a radiation source 41, via optical fibres 42. The photonic crystals are also coupled via optical fibres 43 to detectors 44, which are in turn coupled to a controller 45. The controller 45 afro provides a tuning mechanism 43, such as an optical or electrical tuning mechanism.

In use, radiation generated by the source, such as infrared radiation, is transferred via the optical fibres 42 to the crystals 40. This prevents illuminating radiation interfering with, and consequently being altered by any external factors. The photonic crystals 40 are tailored for specific chemical signatures and therefore direct those specific wavelengths back through the optical fibres where they are coupled out into photodiode detectors 44 where the light is converted to an analogue electrical signal for interpretation by the controller 45.

Alternatively back reflection can be used with the optical fibres delivering the reflected radiation back to the detectors.

The ratios of these signals are compared electronically and if they match a predetermined ratio a gas alarm is signalled.

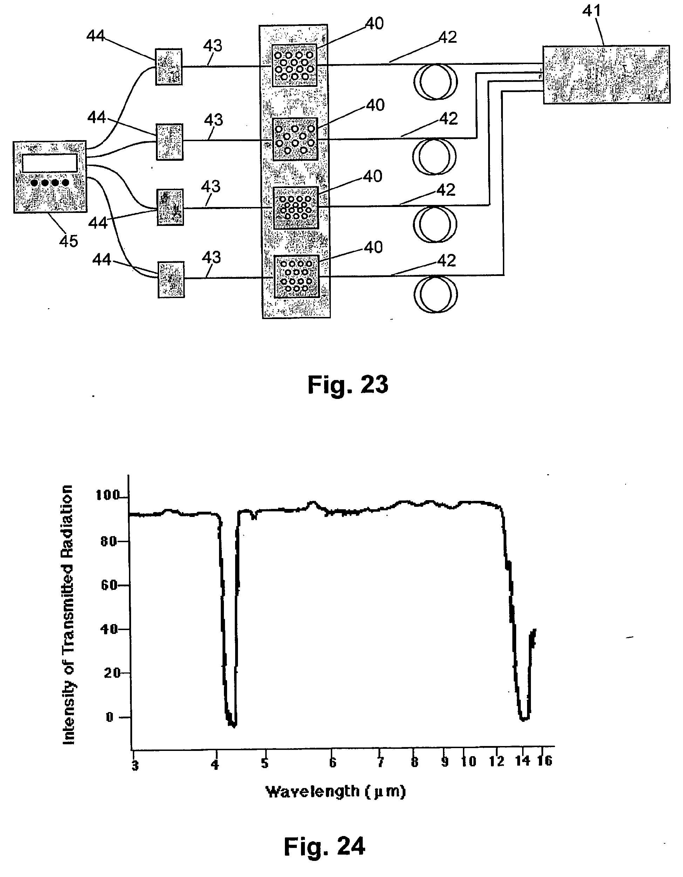

An example of the signature absorption spectra for carbon dioxide is shown in Figure 24. From this, it will be appreciated that if two photonic crystals are provided which reflect at wavelengths corresponding to the absorption peaks in the $CO_2$ spectra, then a reduced reflection at these wavelengths is indicative of the presence of $CO_2$.

A similar system could be used to observe other fluids, such as glucose levels in the blood.

*Photonic Beam Steering*

By generating a photonic crystal structure such as a prism (aka superprism) and using the liquid crystal tuning effect, light entering the photonic crystal can be steered in an arbitrary direction. This may be used for beam steering or multiplexing/demultiplexing the light exiting the structure.

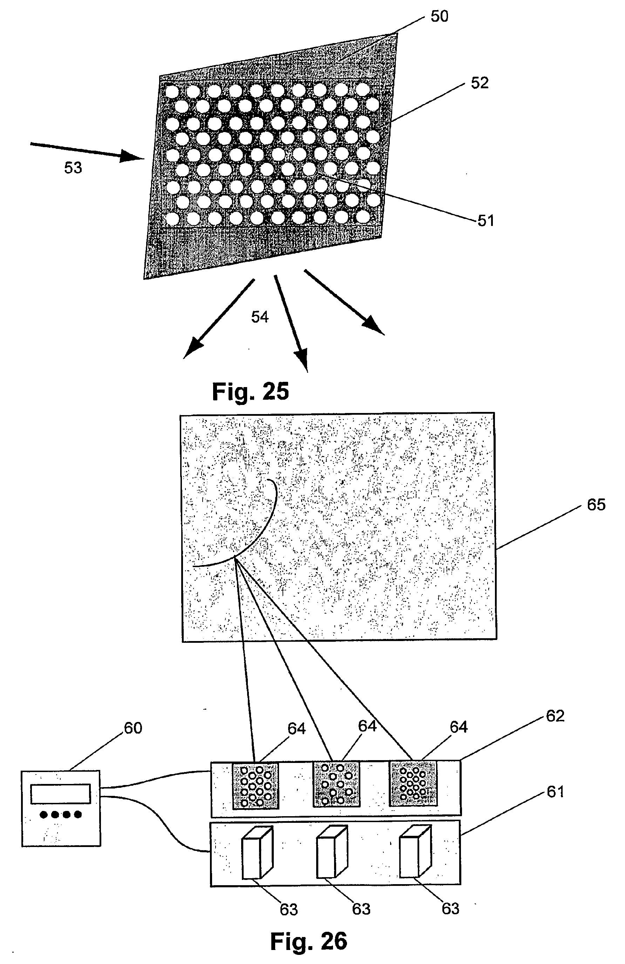

An example photonic crystal for this purpose is shown in Figure 25.

In this example, the crystal is formed from a liquid crystal doped polymer matrix 50 having a generally parallelogram shape. The polymer matrix includes a void rod or void dot structure 51 provided in a square region 52. A radiation beam is input at 53, along one of the edges of the parallelogram shape, such that the radiation is incident on the square region 52 at an angle. Altering the refractive index of the polymer matrix, which is achieved in a manner similar to altering the position of the band gap, by applying a current, or polarised light, allows the angle at which the radiation exits the photonic crystal to be altered as shown by the arrows 54.

It will be appreciated that this allows superprism functionality to be achieved. In particular, a superprism is similar to a conventional optical prism but has two enhanced properties: Firstly super-dispersion and secondly ultrarefraction. Just as a conventional prism separates light into multiple wavelengths, a superprism separates these wavelengths over wider angles: termed super dispersion. A superprism can also be used to magnify the angle of propagation of a single wavelength of light to steer the beam over wide angles: termed ultra refraction. Photonic crystals form the essence of the superprism effect. The highly anisotropic nature of photonic crystals makes propagation of light through the superprism very sensitive to changes in direction, frequency and refractive index.

A number of devices can be developed and manufactured from this beam steering device, as will now be described.

*LIDAR*

A phased array of these devices may allow the exiting beam to be coupled at high angles with scanning times fast enough for LIDAR (LIght Detection and Ranging) applications, using similar principles to RADAR.

*IC Replacement*

Current technology exists to steer a beam using an integrated circuit chip, which has millions of micro mirrors to steer a laser beam. Whilst this is currently in use for disrupting the tracking of a thermally guided missile, such systems are typically unreliable as the mirrors vibrate and become unstable when the device is mounted on an aircraft.

Accordingly, as the beam steering technology has no moving parts it does not suffer from the inherent problems as the micro-mirror device.

*Multiplexing*

The exiting beam can be directed towards an array of output ports therefore enabling this device to act as a multiplexer and/or de-multiplexer.

*Display*

By combining three steering devices, it is possible to independently steer red, blue and green laser beams, thereby allowing the system to be used in providing a laser based display system.

An example of a display system is shown in Figure 27. In this example, the system includes a controller 60 coupled to a laser system 61 and a steering head 62. The laser system 61 includes three beam generators 63, whilst the steering head 62 includes three corresponding photonic crystals 64. In use each photonic crystal 64 is used to steer beams onto a screen 65 or wall and the different combinations of the laser light allows the generation of arbitrary colours. For example, the combination of the red, green and blue lasers results in painting a white picture segment. The combination of the green laser and the red laser generate a yellow colour.

The beam steering allows the laser spots to be translated across the screen to build a bright picture of any chosen colour. The lasers could be scanned in a raster pattern with the output intensity of the lasers modulated to vary the intensity of the colours projected.

Alternatively, the beams could be velocity modulated where the brightness of the spot is determined by the total time at a certain position.

*Tuneable micro-lens*

An arbitrary shaped void structure can be written into the polymer/liquid crystal composite to thereby create an arbitrary lens. The focal length of a lens is a function of the optical distance that the light has to travel, and hence is a function of the refractive index of the material. Therefore, by changing the refractive index this allows the focal length of the lens system to be altered.

This system can be used for multi-focussing lens for multi-layer CD and DVD systems.

This structure may be similar to conventional microlens systems but using our multi-photon ablation process with liquid crystal polymers or it may consist of a photonic crystal lens structure.

*Tuneable lasers*

A laser utilises light amplification within an optical cavity. To achieve this, one end of the cavity is provided so as to be partially transparent thereby allowing the resulting laser beam to be emitted from the cavity.

Using photonic crystals as mirrors at each side of the cavity, this allows a beam to be generated and amplified within the cavity in the normal way. However, the photonic crystals can be used to vary the optical path length of the cavity by tuning the crystals, for example through the use of an applied electric field. This causes the optical path length to change and therefore the wavelength that the laser emits will also change. The variation in index of refraction also causes the photonic crystal mirrors to change their wavelength of reflection, which also tunes the laser output wavelength.

A further modification is that the cavity can be implemented using total reflection at each cavity end to ensure maximum amplification. In this case, when the laser beam is to be emitted, the properties of one of the photonic crystals can be manipulated to allow the laser beam to exit the cavity.

The liquid crystals in the device may also emit fluorescence or another laser dye may be included in the liquid crystal/polymer mixture to act as a gain medium for the light that propagates through the device.

By introducing arbitrary defects into the tuneable photonic crystal, novel laser systems may be engineered. Defects may allow propagation through a gain medium therefore allowing tuneable lasers with very narrow linewidth.

*Polarisation Multiplexing using Defect Structures*

By generating void structures with missing rods or channels, so called "defect structures" can be produced. These structures allow the properties of the device to be tailored.

This can be used for a number of purposes, such as the generation of a photonic crystal splitter, which divides the propagating light in two different pathways. Using the polarising nature of the liquid crystals light of specific polarisations can be sent along a particular path.

This effect may be used for a polarisation multiplexer. Using polarisation preserving optical fibres, different information may be sent down a single fibre with separate polarisations containing different information. This invention will allow the polarisation of the light to be adjusted as the light travels through the structure.

*Optical Switch*

Void channel structures inside liquid crystal doped optical fibres can be used to stop the transmission of light at a particular temperature. The liquid crystals change state when their temperature reaches a particular value, this change in state causes a variation in refractive index and hence a shift in the bandgap. This bandgap shift alters the propagation of light through the fibre ie stops transmission of the light thereby alerting the device that a particular temperature has been reached.

Accordingly, this allows photonic crystals having appropriate void channel structures to be used in caustic radioactive or dangerous environments, where fibres and plastics can withstand these environmental conditions.

Could also be used for aircraft structures (including space shuttle) where temperature sensing is important and where weight is a particular issue.

Similarly, as the properties of the void structures are also effected by electric, magnetic and optical fields, switching can be achieved based on these properties as well.

Accordingly, the above described techniques use a multi-photon micro-fabrication process that allows the creation of arbitrary photonic crystal structures in an active medium.

The active medium can be formed from liquid crystals doped into a polymer host to form a liquid crystal-polymer composite formed by doping the polymer with liquid crystals in the form of tiny droplets, which are homogenously mixed throughout the polymer matrix. The liquid crystal droplet size can be varied by the manufacture process but can range from a few nanometres to a few hundred micrometres.

The photonic crystals structures are drilled into the liquid crystal/polymer composite with the creation of void channels that provided the dielectric contrast required. An applied electric field or polarised radiation beam alters the index of refraction of the structure and hence the position of the photonic bandgap.

The structures are created by a multi-photon laser micro-explosion in the polymer matrix. This micro-explosion is translated in the x-y- or z axis to allow void channels or other structures to be created. By creating a number of void channels any desired structure can be generated, which in turn allows one, two or three-dimensional photonic crystals of arbitrary lattice constant to be produced.

The liquid crystals have an optical anisotropy and their physical position can be altered with the application of an electric or optical field, thereby altering the refractive index of the material as a whole. This change in refractive index alters the Bragg condition and hence the wavelength of the bandgap moves.

As any arbitrary structure can be generated, this allows tuneable or active photonic crystals to be formed by varying the structures as requirements dictate. Accordingly, this provides a method to produce tuneable photonic crystals that involves the use of a controlled multi-photon ablation process.

Persons skilled in the art will appreciate that numerous variations and modifications will become apparent. All such variations and modifications which become apparent to persons skilled in the art should be considered to fall within the scope that the invention broadly appearing before described.

**Claims**

1. A method of forming an optically active element in the form of a photonic crystal, the method including:

      (a) creating a matrix (1) wherein the matrix material is doped with an optically active material dispersed there through; and
      (b) generating one or more void structures (2) using a radiation beam in the matrix (1).

2. A method according to claim 1, wherein the method includes forming the void structures (2) using a laser micro-fabrication process to induce local micro-explosions at a focal spot.

3. A method according to any one of claims 1 and 2, wherein the method includes:

      (a) heating a polymer; and,
      (b) dispersing liquid crystal throughout the polymer to form the matrix (1).

4. A method according to claim 3; wherein the liquid crystals are dispersed so as to form droplets homogenously dispersed throughout the solidified polymeric matrix (1).

**5.** A method according to claim 3 or claim 4, wherein the polymer is a thermoset resin.

**6.** A method according to any one of claims 3 to 5, wherein the polymer is an unsaturated cross-linked polymer.

**7.** A method according to claim 6, wherein the polymer matrix (1) is a polyurethane oligomer with C=C unsaturation and cross-linked by a thiol-ester oligomer

**8.** A method according to any one of claims 3 to 7, wherein the liquid crystal has an order parameter of between 0.3 and 0.9;

**9.** A method according to any one of claims 3 to 8, wherein the liquid crystal is a eutectic mixture containing 4-pentyl 4-cyano biphenyl.

**10.** A method according to any one of claims 3 to 9, wherein the method includes:

    (a) heating a polymer material to reduce its viscosity;
    (b) adding the liquid crystal to the heated polymer material; and,
    (c) agitating the resulting mixture for a predetermined time period to thereby disperse the liquid crystals through the polymer material.

**11.** A method according to any one of claims 3 to 10, wherein the method further includes curing the resulting mixture in an ultraviolet curing oven to thereby cause the resulting mixture to solidify such that the liquid crystals form droplets homogenously dispersed mixed through the solidified polymer.

**12.** A method according to claim 11, wherein the resulting material is cured for at least 30 minutes.

**13.** A method according to any one of claims 3 to 12, wherein the method further includes adding one or more dopants to the matrix (1), the dopants being adapted to modify at least one of:

    (a) a relaxation rate of the optically active material; and,
    (b) optical properties of the matrix (1).

**14.** A method according to claim 13, wherein the dopants include at least one of:

    (a) a photo-absorber;
    (b) a plasticiser;
    (c) inhibitors;
    (d) stabilisers;
    (e) flame retarders;
    (f) hardening agents;
    (a) quantum dots;
    (b) nano particles;
    (c) nano crystals;
    (g) colouring agents; and,
    (h) dyes.

**15.** A method according to any one of claims 1 to 14, wherein the method includes providing a layer of indium tin oxide on opposing surfaces of the matrix (1) to thereby allow an electrical potential to be applied thereto.

**16.** A method according to claim 15, wherein the method includes forming the matrix (1) on a substrate, at least one of the indium tin oxide layers being provided on the substrate using vacuum deposition.

**17.** A method according to any one of claims 1 to 16, wherein the method includes generating void structures (2) by:

    (a) generating a beam of radiation;
    (b) modulating the radiation beam; and
    (c) focussing the modulated radiation beam onto the polymer matrix (1) to thereby selectively generate void structures (2).

**18.** A method according to claim 17, wherein the method further includes:

(a) filtering the radiation beam; and,
(b) collimating the radiation beam.

**19.** A method according to claim 17 or claim 18, wherein the method includes controlling the relative position of the matrix (1) and the radiation beam to thereby generate a predetermined void structure.

**20.** A method according to any one of claims 17 to 19, wherein the method includes using a radiation beam having at least one of:

(a) a wavelength of between 600 and 800 nm;
(b) a pulse width of between 70 and 90 fs;
(c) a repetition rate in the region of 82 MHz;
(d) a writing speed of between 400 and 600 $\mu$m/s; and,
(e) a power of between 10 and 20 mW at the objective lens.

**21.** A method according to any one of claims 1 to 20, wherein the optically active element is adapted for use in:

(a) a display;
(b) beam steering;
(c) fluid detection;
(d) tunable lasers;
(e) polarisation multiplexing; and,
(f) optical switching.

**22.** A method according to any one of the claims 1 to 21, wherein the void structure includes at least one of:

(a) one or more void channels;
(b) void dots; and,
(c) one or more layers of void channels.

**23.** A method according to any one of the claims 1 to 22, wherein the void structure includes a plurality of layers of void channels, the void channels in each layer being substantially parallel, and the void channels in adjacent layers being substantially orthogonal.

**24.** A method according to claim 23, wherein the structure defines a bandgap, the wavelength of the bandgap being at least partially dependent on a separation of the layers.

**Patentansprüche**

**1.** Verfahren zur Bildung eines optisch aktiven Elements in Form eines fotonischen Kristalls, wobei das Verfahren einschließt:

(a) Herstellen einer Matrix (1), wobei das Matrixmaterial mit einem optisch aktiven Material dotiert ist, das dort hindurch dispergiert ist; und
(b) Erzeugen einer oder mehrerer Leerstellenstrukturen (2) unter Verwendung eines Strahlenbündels in der Matrix (1).

**2.** Verfahren nach Anspruch 1, wobei das Verfahren die Bildung von Leerstellenstrukturen (2) unter Verwendung eines Laser-Mikrofertigungsprozesses einschließt, um lokale Mikroexplosionen an einem Brennpunkt zu induzieren.

**3.** Verfahren nach einem der Ansprüche 1 und 2, wobei das Verfahren einschließt:

(a) Erwärmen eines Polymers; und,
(b) Dispergieren von Flüssigkristall überall im Polymer, um die Matrix (1) zu bilden.

**4.** Verfahren nach Anspruch 3, wobei die Flüssigkristalle dispergiert sind, um Tröpfchen zu bilden, die überall in der verfestigten polymeren Matrix (1) homogen dispergiert sind.

**5.** Verfahren nach Anspruch 3 oder Anspruch 4, wobei das Polymer ein duroplastisches Harz ist.

**6.** Verfahren nach einem der Ansprüche 3 bis 5, wobei das Polymer ein ungesättigtes vernetztes Polymer ist.

**7.** Verfahren nach Anspruch 6, wobei die Polymermatrix (1) ein Polyurethan-Oligomer mit C=C Ungesättigtheit ist und durch ein Thiolester-Oligomer vernetzt ist.

**8.** Verfahren nach einem der Ansprüche 3 bis 7, wobei der Flüssigkristall einen Ordnungsparameter von zwischen 0,3 und 0,9 aufweist.

**9.** Verfahren nach einem der Ansprüche 3 bis 8, wobei der Flüssigkristall eine eutektische Mischung ist, die 4-Pentyl 4-Cyanobiphenyl enthält.

**10.** Verfahren nach einem der Ansprüche 3 bis 9, wobei das Verfahren einschließt:

(a) Erwärmen eines Polymermaterials, um dessen Viskosität zu reduzieren;
(b) Hinzufügen des Flüssigkristalls zum erwärmten Polymermaterial; und,
(c) Rühren der resultierenden Mischung für eine vorbestimmte Zeitdauer, um dadurch die Flüssigkristalle durch das Polymermaterial zu dispergieren.

**11.** Verfahren nach einem der Ansprüche 3 bis 10, wobei das Verfahren ferner das Härten der resultierenden Mischung in einem Ultraviolett-Aushärteofen einschließt, um dadurch zu bewirken, dass sich die resultierende Mischung derart verfestigt, dass die Flüssigkristalle Tröpfchen bilden, die homogen dispergiert durch das verfestigte Polymer vermischt sind.

**12.** Verfahren nach Anspruch 11, wobei das resultierende Material für wenigstens 30 Minuten ausgehärtet wird.

**13.** Verfahren nach einem der Ansprüche 3 bis 12, wobei das Verfahren ferner das Hinzufügen eines oder mehrerer Dotierstoffe zur Matrix (1) einschließt, wobei die Dotierstoffe angepasst sind, wenigstens eins der Folgenden zu modifizieren:

(a) eine Relaxationsgeschwindigkeit des optisch aktiven Materials; und,
(b) optische Eigenschaften der Matrix (1).

**14.** Verfahren nach Anspruch 13, wobei die Dotierstoffe wenigstens eins der Folgenden einschließen:

(a) einen Fotoabsorber;
(b) ein Plastifiziermittel;
(c) Inhibitoren;
(d) Stabilisiermittel;
(e) Flammverzögerungsmittel;
(f) Härtemittel;
(a) Quantenpunkte;
(b) Nanoteilchen;
(c) Nanokristalle;
(g) Färbemittel; und,
(h) Farbstoffe.

**15.** Verfahren nach einem der Ansprüche 1 bis 14, wobei das Verfahren das Bereitstellen einer Schicht aus Indiumzinnoxid auf gegenüberliegenden Oberflächen der Matrix (1) einschließt, um dadurch zu ermöglichen ein elektrisches Potenzial darauf anzuwenden.

**16.** Verfahren nach Anspruch 15, wobei das Verfahren das Bilden der Matrix (1) auf einem Substrat einschließt, wobei wenigstens eine der Indiumzinnoxid-Schichten auf dem Substrat unter Verwendung von Vakuumablagerung bereitgestellt ist.

**17.** Verfahren nach einem der Ansprüche 1 bis 16, wobei das Verfahren die Erzeugung von Leerstellenstrukturen (2) einschließt durch:

(a) Erzeugen einer gebündelten Strahlung;
(b) Modulieren des Strahlenbündels; und
(c) Fokussieren des modulierten Strahlenbündels auf die Polymermatrix (1), um dadurch selektiv Leerstellenstrukturen (2) zu erzeugen.

**18.** Verfahren nach Anspruch 17, wobei das Verfahren ferner einschließt:

(a) Filtern des Strahlenbündels; und,
(b) Kollimation des Strahlenbündels.

**19.** Verfahren nach Anspruch 17 oder Anspruch 18, wobei das Verfahren das Steuern der relativen Position der Matrix (1) und des Strahlenbündels einschließt, um dadurch eine vorbestimmte Leerstellenstruktur zu erzeugen.

**20.** Verfahren nach einem der Ansprüche 17 bis 19, wobei das Verfahren die Verwendung eines Strahlenbündels einschließt, das wenigstens eins der Folgenden aufweist:

(a) eine Wellenlänge von zwischen 600 und 800 nm;
(b) eine Impulsbreite von zwischen 70 und 90 fs;
(c) eine Wiederholungsfrequenz im Bereich von 82 MHz;
(d) eine Schreibgeschwindigkeit von zwischen 400 und 600 $\mu$m/s; und,
(e) eine Energie von zwischen 10 und 20 mW an der Objektivlinse.

**21.** Verfahren nach einem der Ansprüche 1 bis 20, wobei das optisch aktive Element zur Verwendung in Folgenden angepasst ist:

(a) einem Display;
(b) Strahlsteuerung;
(c) Fluiddetektion;
(d) abstimmbare Laser;
(e) Polarisationsmultiplexen; und,
(f) optischer Schaltung.

**22.** Verfahren nach einem der Ansprüche 1 bis 21, wobei die Leerstellenstruktur wenigstens eins der Folgenden einschließt:

(a) einen oder mehrere Leerstellenkanäle;
(b) Leerstellenpunkte; und,
(c) eine oder mehrere Schichten von Leerstellenkanälen.

**23.** Verfahren nach einem der Ansprüche 1 bis 22, wobei die Leerstellenstruktur eine Vielzahl von Schichten von Leerstellenkanälen einschließt, wobei die Leerstellenkanäle in jeder Schicht im Wesentlichen parallel sind und die Leerstellenkanäle in angrenzenden Schichten im Wesentlichen orthogonal sind.

**24.** Verfahren nach Anspruch 23, wobei die Struktur eine Bandlücke definiert, wobei die Wellenlänge der Bandlücke wenigstens teilweise von einer Trennung der Schichten abhängt.

## Revendications

**1.** Procédé de fabrication d'un élément optiquement actif sous la forme d'un cristal photonique, le procédé comportant les étapes consistant à :

(a) créer une matrice (1), le matériau de la matrice étant dopé au moyen d'un matériau optiquement actif dispersé au travers de celui-ci ; et
(b) générer une ou plusieurs structures vides (2) au moyen d'un faisceau de rayonnement dans la matrice (1).

**2.** Procédé selon la revendication 1, dans lequel le procédé comprend l'étape consistant à former les structures vides (2) au moyen d'un processus de micro-fabrication par laser pour induire des micro-explosions locales au niveau d'un point focal.

**3.** Procédé selon l'une quelconque des revendications 1 et 2, dans lequel le procédé comprend les étapes consistant à :

(a) chauffer un polymère ; et
(b) disperser du cristal liquide dans l'ensemble du polymère pour former la matrice (1).

**4.** Procédé selon la revendication 3, dans lequel les cristaux liquides sont dispersés de façon à former des gouttelettes dispersées de manière homogène dans l'ensemble de la matrice polymère solidifiée (1).

**5.** Procédé selon la revendication 3 ou la revendication 4, dans lequel le polymère est une résine thermodurcie.

**6.** Procédé selon l'une quelconque des revendications 3 à 5, dans lequel le polymère est un polymère réticulé insaturé.

**7.** Procédé selon la revendication 6, dans lequel la matrice polymère (1) est un oligomère de type polyuréthane avec une insaturation C=C et avec une réticulation effectuée par un oligomère de type ester de thiol.

**8.** Procédé selon l'une quelconque des revendications 3 à 7, dans lequel le cristal liquide a un paramètre d'ordre compris entre 0,3 et 0,9.

**9.** Procédé selon l'une quelconque des revendications 3 à 8, dans lequel le cristal liquide est un mélange eutectique contenant du biphényle de 4-pentyl 4-cyano.

**10.** Procédé selon l'une quelconque des revendications 3 à 9, dans lequel le procédé comprend les étapes consistant à :

(a) chauffer un matériau polymère pour réduire sa viscosité ;
(b) ajouter le cristal liquide au matériau polymère chauffé ; et,
(c) agiter le mélange résultant pendant une période de temps prédéterminée pour de ce fait disperser les cristaux liquides dans l'ensemble du matériau polymère.

**11.** Procédé selon l'une quelconque des revendications 3 à 10, dans lequel le procédé comprend par ailleurs l'étape consistant à faire sécher le mélange résultant dans un four de séchage ultraviolet pour de ce fait amener le mélange résultant à se solidifier de telle sorte que les cristaux liquides forment des gouttelettes dispersées de manière homogène dans l'ensemble du polymère solidifié.

**12.** Procédé selon la revendication 11, dans lequel le matériau résultant est séché pendant au moins 30 minutes.

**13.** Procédé selon l'une quelconque des revendications 3 à 12, dans lequel le procédé comprend par ailleurs l'étape consistant à ajouter un ou plusieurs dopants à la matrice (1), les dopants étant adaptés pour modifier au moins l'un parmi :

(a) un taux de relaxation du matériau optiquement actif ; et,
(b) des propriétés optiques de la matrice (1).

**14.** Procédé selon la revendication 13, dans lequel les dopants comprennent au moins l'un parmi :

(a) un photo absorbeur ;
(b) un plastifiant ;
(c) des inhibiteurs ;
(d) des stabilisants ;
(e) des ignifugeants ;
(f) des agents de durcissement ;
(a) des points quantiques ;
(b) des nanoparticules ;
(c) des nanocristaux ;
(g) des agents colorants ; et,

(h) des teintures.

15. Procédé selon l'une quelconque des revendications 1 à 14, dans lequel le procédé comprend l'étape consistant à mettre en oeuvre une couche d'oxyde d'étain et d'indium sur des surfaces opposées de la matrice (1) pour de ce fait permettre l'application d'un potentiel électrique sur celle-ci.

16. Procédé selon la revendication 15, dans lequel le procédé comprend l'étape consistant à former la matrice (1) sur un substrat, au moins l'une des couches d'oxyde d'étain et d'indium étant mise en oeuvre sur le substrat en utilisant une opération de dépôt par évaporation sous vide.

17. Procédé selon l'une quelconque des revendications 1 à 16, dans lequel le procédé comprend l'étape consistant à générer des structures vides (2) par les étapes consistant à :

    (a) générer un faisceau de rayonnement ;
    (b) moduler le faisceau de rayonnement ; et
    (c) focaliser le faisceau de rayonnement modulé sur la matrice polymère (1) pour de ce fait générer de manière sélective des structures vides (2).

18. Procédé selon la revendication 17, dans lequel le procédé comprend par ailleurs les étapes consistant à :

    (a) filtrer le faisceau de rayonnement ; et,
    (b) collimater le faisceau de rayonnement.

19. Procédé selon la revendication 17 ou la revendication 18, dans lequel le procédé comprend l'étape consistant à commander la position relative de la matrice (1) et du faisceau de rayonnement pour de ce fait générer une structure vide prédéterminée.

20. Procédé selon l'une quelconque des revendications 17 à 19, dans lequel le procédé comprend l'étape consistant à utiliser un faisceau de rayonnement ayant au moins l'un parmi :

    (a) une longueur d'onde comprise entre 600 et 800 nm ;
    (b) une largeur d'impulsion comprise entre 70 et 90 fs ;
    (c) un taux de répétition dans la région de 82 MHz ;
    (d) une vitesse d'écriture comprise entre 400 et 600 $\mu$m/s ; et,
    (e) une puissance comprise entre 10 et 20 mW au niveau de l'objectif.

21. Procédé selon l'une quelconque des revendications 1 à 20, dans lequel l'élément optiquement actif est adapté à des fins d'utilisation dans :

    (a) un affichage ;
    (b) une orientation de faisceau ;
    (c) une détection de fluide ;
    (d) des lasers accordables ;
    (e) un multiplexage de polarisation ; et,
    (f) une commutation optique.

22. Procédé selon l'une quelconque des revendications 1 à 21, dans lequel la structure vide comprend au moins l'un parmi :

    (a) un ou plusieurs canaux vides ;
    (b) des points vides ; et,
    (c) une ou plusieurs couches de canaux vides.

23. Procédé selon l'une quelconque des revendications 1 à 22, dans lequel la structure vide comprend une pluralité de couches de canaux vides, les canaux vides dans chaque couche étant sensiblement parallèles, et les canaux vides dans des couches adjacentes étant sensiblement perpendiculaires.

24. Procédé selon la revendication 23, dans lequel la structure définit une bande interdite, la longueur d'onde de la bande interdite étant au moins partiellement dépendante d'une séparation des couches.

**Fig. 1**

**Fig. 2**

Fig. 3

Fig. 4

## Fig. 6A

## Fig. 6B

**Fig. 7A**

**Fig. 7B**

**Fig. 8**

**Fig. 9**

Norland resin (NOA63) with 6.5% Liquid Crystal (E49)

## Fig. 10

## Fig. 11

**Fig. 12A**

**Fig. 12B**

**Fig. 13A**

**Fig. 13B**

**Fig. 14A**

**Fig. 14B**

**Fig. 14C**

**Fig. 5**

Fig. 15

Fig. 16A

**Fig. 16B**

**Fig. 16C**

Fig. 17

Fig. 18

**Fig. 19**

**Fig. 20A**

**Fig. 20B**

Fig. 21

Fig. 22C

Fig. 22D

Fig. 22A

Fig. 22B

**Fig. 23**

**Fig. 24**

50

52

53

51

54

**Fig. 25**

65

60

64 64 64

62

61

63 63 63

**Fig. 26**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004034134 A

**Non-patent literature cited in the description**

- **XIANG.** Fabrication of BaTiO3 Inverse Opal Photonic Crystal. *Chinese Chemical Letters,* 2004, vol. 15 (2), 228-230

- Void channel microstructures in resin solids as an efficient way to infrared photonic crystals. **VENTURA M. J. et al.** Applied Physics Letters. American Institute Of Physics, 17 March 2003, vol. 82